# EUROPEAN PATENT APPLICATION

(11) **EP 2 299 584 A1**
(43) Date of publication of application: **23.03.2011**
(21) Application number: 09770219.5
(22) Date of filing: 25.06.2009
(51) Int. Cl.: H02N 1/00, B81B 3/00, G02B 26/08, G02B 26/10

(54) **MOVING STRUCTURE AND LIGHT SCANNING MIRROR USING SAME**

(30) Priority: 25.06.2008 JP 2008166584; 17.07.2008 JP 2008185893; 17.07.2008 JP 2008186189
(71) Applicant: Panasonic Electric Works Co., Ltd., Kadoma-shi, Osaka 571-8686 (JP)
(72) Inventor: TACHIBANA, Hiroaki, Kadoma-shi Osaka 571-8686 (JP); NOGE, Hiroshi, Kadoma-shi Osaka 571-8686 (JP); KAWANO, Kiyohiko, Kadoma-shi Osaka 571-8686 (JP); UEDA, Hideki, Kadoma-shi Osaka 571-8686 (JP)
(74) Representative: Appelt, Christian W.
(86) International application number: PCT/JP2009/061583
(87) International publication number: WO 2009/157509

(57) **Abstract**

In a semiconductor mechanical structure, hinges may not be broken even when a mechanical shock is applied from outside, and thus, crashworthy is enhanced. A light scanning mirror (1) comprises a moving plate (2), a twin hinges (3) constituting an axis of swing motion of the moving plate (2) wherein an end of each hinge is connected to both ends of the moving plate (2), a stationary frame (4) which is disposed to surround peripheries of the moving plate (2) and supports another end of each of the twin hinges (3), and stoppers (6) formed on the stationary frame (4). When the moving plate (2) displaces in a lateral direction, the stopper (6) contacts a side end portion of a recess (2e) of the moving plate (2), so that the displacement of the moving plate (2) in the lateral direction is restrained. Thereby, the breakage of the hinges (3) is prevented even when the mechanical shock is applied from outside.

## Description

### Technical Field

The present invention relates to a moving structure having a moving plate which is formed on a semiconductor substrate and configured to be pivoted swingably by hinges.

### Background Art

Conventionally, it is known that some optical instruments such as bar-code readers or projectors use a light scanning mirror to scan light beams incident to a mirror by swinging a moving plate to which the mirror is provided (see patent document 1 to patent document 3, for example). As for the light scanning mirror, a miniature one having a semiconductor moving structure formed by using micro machining technology is known. Such a moving structure has a moving plate to which a mirror face is formed when it is used as a light scanning mirror and a stationary frame which supports the moving plate. The moving plate and the stationary frame are coupled by hinges each other. The moving plate is driven by a pair of comb tooth electrodes facing each other and formed between the moving plate and the stationary frame, for example. The comb tooth electrodes are formed so that each other's electrodes are engaged at an interval of several µm with each other, and generate electrostatic forces when voltages are applied between the each other's electrodes. The moving plate rotates with respect to the stationary frame while twisting the hinges by driving forces generated by the comb tooth electrodes, and thus, swings around the hinges serving as an axis.

By the way, in such a light scanning mirror, in order to assure swing angle necessary to scan light by a small driving voltage, it is sufficient to decrease a spring constant of the hinges in torsion direction by thinning the hinges. However, when thinning the hinges, the hinges become weak for a physical shock, and the hinges may be broken when a mechanical shock is applied from outside, and thus, the light scanning mirror may become immovable.

The patent document 1 discloses a structure of a light scanning mirror in which a cover substrate is joined to a semiconductor substrate. However, even though the cover substrate is provided, displacement of the moving plate is not restrained in such a structure, when a mechanical shock is applied from outside, the hinges may be broken before the moving plate contacts the cover substrate. In addition, the patent document 2 discloses a micro-mirror device in which a pivot which can support a central portion serving as a center of inclination of a moving plate is formed. However, there is a problem that the micro-mirror device is not easily manufactured because the pivot is necessary to be formed precisely at a predetermined position to correspond to the central portion of the moving plate and proximate to the moving plate.

By the way, the comb tooth electrodes used for such a light scanning mirror are configured by many comb tooth formed to be very thin to generate large electrostatic forces. When vibrations or a mechanical shock are/is applied to the light scanning mirror from outside and a quantity of displacement in lateral direction becomes larger, the comb tooth electrodes provided on the moving plate may contact a stationary frame, or the comb tooth electrodes provided on the stationary frame may contact the moving plate, and so on. Since each comb teeth is thin and weak, it may be broken due to it contacts the stationary frame or the moving plate.

### Prior Art Documents

### Patent Documents

Patent Document 1: JP 2004-109651A
Patent Document 2: JP 2003-57575A
Patent document 3: JP 2004-13099A

### Summary of Invention

### Problems that the Invention is going to Solve

The present invention is conceived in consideration of the above mentioned problems and purposed to provide a moving structure and a light scanning mirror using the same, which can be manufactured easily and has a high crashworthy even because the hinges and the comb tooth electrodes are nonbreakable even when a mechanical shock is applied from outside.

### Means to solve the Problems

For achieving the above mentioned purpose, the invention of claim 1 relates to a moving structure comprising a moving plate, twin hinges constituting an axis of swing motion of the moving plate wherein an end of each hinge is connected to the moving plate, and a frame to which another end of each of the twin hinges is connected and which supports the hinges, and wherein the moving plate is configured swingable with respect to the frame while twisting the twin hinges, characterized in that stoppers, which restrain a displacement of the moving plate by contacting a part of the moving structure when the moving plate displaces, are further comprised.

The invention of claim 2 is characterized in that the stoppers are provided to restrain the displacement of the moving plate in in-plane direction, in the moving structure described in claim 1.

The invention of claim 3 is characterized in that the stoppers are formed along the hinges in sides of the hinges, in the moving structure described in claim 1 or claim 2.

The invention of claim 4 is characterized in that comb tooth electrodes, which are formed on a part of the moving plate and a part of the frame to face each other, and swing the moving plate with respect to the frame, are further comprised, and the stoppers are disposed to contact another portion of the moving structure except the comb tooth electrodes, when the moving plate displaces in the in-plane direction, in the moving structure described in claim 1 or claim 2.

The invention of claim 5 is characterized in that the stoppers are integrally formed with the moving plate or the frame, in the moving structure described in one of claim 1 to claim 4.

The invention of claim 6 is characterized in that recesses are provided on the moving plate so that they are formed to be concaved in a longitudinal direction of the hinges in the vicinities of portions pivoted by the hinges, and the stoppers are integrally formed with the frame and formed to be located between the hinges and side end portions of the moving plate to which the recesses are formed, in the moving structure described in claim 3.

The invention of claim 7 is characterized in that a chamfer of a round shape is formed at each corner of the stoppers, in the moving structure described in one of claim 1 to claim 6.

The invention of claim 8 is characterized in that the stoppers are configured to be the same electric potential as that of another portion of the moving structure which contacts the stopper when the moving plate displaces in a lateral direction, in the moving structure described in one of claim 1 to claim 7.

The invention of claim 9 is characterized in that a sticking prevention film or a protrusion is formed on at least a part of each of the stopper so as not to occur sticking between the stopper and one which contacts the stopper, in the moving structure described in one of claim 1 to claim 8.

The invention of claim 10 is characterized in that the stoppers are provided to restrain the displacement of the moving plate in thickness direction, in the moving structure described in claim 1.

The invention of claim 11 is characterized in that the moving plate, the hinges and the frame are provided on a semiconductor substrate, a protection substrate for protecting the moving plate is joined to at least one face of the semiconductor substrate, and the stoppers are protruded toward a center axis of swing motion of the moving plate from the protection substrate, in the moving structure described in claim 10.

The invention of claim 12 is characterized in that the stoppers are formed at positions distant from the hinges so as not to contact the hinges when the moving plate displaces, in the moving structure described in claim 11.

The invention of claim 13 is characterized in that each of the stoppers include an upper stopper disposed in a top face side of the moving plate, and the upper stopper is formed to protrude toward a center axis of swing motion of the hinges so as to restrain the displacement of the moving plate by contacting the moving plate in displacement of the moving plate, in the moving structure described in claim 12.

The invention of claim 14 is characterized in that a supporting member is integrally formed with the moving plate below a bottom face of the moving plate, the stoppers include a lower stopper disposed in a bottom face side of the moving plate, and the lower stopper is formed to protrude toward a center axis and along the center axis of swing motion of the hinges so as to restrain the displacement of the moving plate by contacting the supporting member which displaces integrally with the moving plate in displacement of the moving plate, in the moving structure described in claim 12.

The invention of claim 15 relates to a light scanning mirror characterized in that it has the moving structure described in one of claim 1 to claim 14, and a mirror face for reflecting incident light is provided on a top face of the moving plate.

### Effects of the Invention

According to the invention of claim 1, since the stoppers restrain the displacement of the moving plate by contacting a part of the moving structure, the hinges and the comb tooth electrodes become hard to be broken even when a mechanical shock is applied to them from outside. Thereby, it is possible to enhance crashworthy of the moving structure.

According to the invention of claim 2, even when the moving plate displaces in the in-plane direction by acting on the mechanical shock from outside, a quantity of the displacement of the moving plate in the in-plane direction is restrained by the stoppers. Therefore, since the moving plate may not displace largely, and thus, breakages of the hinges can be prevented, it is possible to enhance crashworthy of the moving structure.

According to the invention of claim 3, since the stoppers are disposed in the vicinities of the hinges, it is possible to restrain the displacement of the moving plate in the in-plain direction effectively, even when the moving plate is inclined with respect to the frame. In addition, since level of precision required to locations and shapes of the stoppers is lower in comparison with the conventional case of forming a pivot shaped protrusion, the moving structure can be manufactured relatively easier. Moreover, since the stoppers may not contact the hinges, it is possible to prevent the breakage of the hinges surely.

According to the invention of claim 4, since the comb tooth of the comb tooth electrodes may not contact the moving plate, the frame or the like, it is possible to prevent the breakage of the comb tooth electrodes and to enhance the crashworthy of the moving structure.

According to the invention of claim 5, since the stoppers can be formed easily by processing a member which constitutes the moving plate or the frame when forming the moving plate or the frame, the moving structure can be manufactured much easier.

According to the invention of claim 6, the quantity of the displacement of the moving plate can be restrained by contacting the stopper with a side of the recess in the displacement of the moving plate. Therefore, it is possible to configure a structure to restrain the quantity of the displacement of the moving plate much easier and stronger.

According to the invention of claim 7, since there is no aculeate shape at a portion of each of the stoppers which contacts another portion of the moving structure in the displacement of the moving plate, it becomes difficult to concentrate stress to the stopper and the portion contacting with the stopper when the portion contact. Therefore, it is possible to prevent the breakage of the stopper or the portion of the moving structure contacting the stopper.

According to the invention of claim 8, even when the stopper contacts another portion of the moving structure due to the displacement of the moving plate in a lateral direction, it is possible to prevent that the moving plate becomes immovable to swing due to occurrence of sticking by electrostatic force.

According to the invention of claim 9, even when the stopper contacts another portion of the moving structure due to the displacement of the moving plate in a lateral direction, it is possible to prevent that the moving plate becomes immovable to swing because occurrence of sticking is prevented by the sticking prevention film or the protrusion.

According to the invention of claim 10, since the displacement of the moving plate in thickness direction is restrained by the stopper, it is possible to prevent the breakage of the hinge even when a mechanical shock is applied to the moving plate in the thickness direction from outside.

According to the invention of claim 11, since the stoppers protrude toward the axis of swing motion at which the displacement of the moving plate is small in the displacement of the moving plate, it is possible to locate the stoppers near to the moving plate without blocking the swing motion of the moving plate around the hinges serving as an axis and to restrain the displacement of the moving plate in a direction perpendicular to the semiconductor substrate, effectively.

According to the invention of claim 12, since the stoppers do not contact with the hinges, it is possible to prevent trouble that the hinge may be broken by contacting with the stopper.

According to the invention of claim 13, it is possible to restrain the displacement of the moving plate in upper side direction by contacting the upper stopper with the moving plate. Thereby, it is possible to enhance the crashworthy of the moving structure easier by a simple structure.

According to the invention of claim 14, it is possible to restrain the displacement of the moving plate in a lower side by contacting the lower stopper with the moving plate. Thereby, it is possible to enhance the crashworthy of the moving structure easier by a simple structure.

According to the invention of claim 15, it is possible to enhance the crashworthy of the light scanning mirror and to manufacture the light scanning mirror easily.

### Brief Description of Drawings

FIG. 1 (a) is a perspective view showing an upper side of a light scanning mirror which is a moving structure in accordance with a first embodiment of the present invention, and FIG. 1(b) is a perspective view showing a lower side of the light scanning mirror;
FIG. 2 is a plain view of the above light scanning mirror;
FIG. 3 is an A-A sectional view in FIG. 2;
FIG. 4(a) is a plain view showing a portion of the above light scanning mirror in the vicinity of stoppers, and FIG. 4(b) is a plain view showing the same part when the moving plate displaces from normal state;
FIG. 5 is a perspective view showing a light scanning mirror in accordance with a second embodiment of the present invention;
FIG 6(a) is a plain view showing a portion of the above light scanning mirror in the vicinity of stoppers, and FIG. 6(b) is a plain view showing the same part when the moving plate displaces from normal state;
FIG. 7 is a perspective view showing a light scanning mirror in accordance with a third embodiment of the present invention;
FIG. 8(a) is a plain view showing a portion of the above light scanning mirror in the vicinity of stoppers, and FIG. 8(b) is a plain view showing the same part when the moving plate displaces from normal state;
FIG. 9 is a plain view showing a portion of a light scanning mirror in the vicinity of stoppers in accordance with a fourth embodiment of the present invention;
FIG. 10 is a perspective view showing a light scanning mirror in accordance with a fifth embodiment of the present invention;
FIG. 11 is a plain view of the above light scanning mirror;
FIG. 12 is an A-A sectional view in FIG. 11;
FIG. 13 is a plain view showing a portion of the above light scanning mirror in the vicinity of stoppers;
FIG. 14 is a plain view showing stoppers in a first modification of the above light scanning mirror;
FIG. 15 is a perspective view showing a light scanning mirror in accordance with a sixth embodiment of the present invention;
FIG 16 is an exploded perspective view showing an example of a light scanning mirror which is a moving structure in accordance with a seventh embodiment of the present invention;
FIG. 17(a) is a perspective view showing an upper side of the above light scanning mirror, and FIG. 17(b) is a perspective view showing a lower side of the same light scanning mirror;
FIG. 18 is an A-A sectional view in FIG. 17(a);
FIG. 19 is a sectional side view in a manufacturing process of a semiconductor portion of the above light scanning mirror;
FIG. 20 is a sectional side view in a manufacturing process of the above light scanning mirror;
FIG. 21 is a sectional side view in a manufacturing process of the semiconductor portion of the above light scanning mirror;
FIG. 22 is a sectional side view in a manufacturing process of the semiconductor portion of the above light scanning mirror;
FIG. 23 is a sectional side view in a manufacturing process of the semiconductor portion of the above light scanning mirror; and
FIG. 24 is a sectional side view in a manufacturing process of the above light scanning mirror.

### Mode for Carrying Out the Invention

### (First Embodiment)

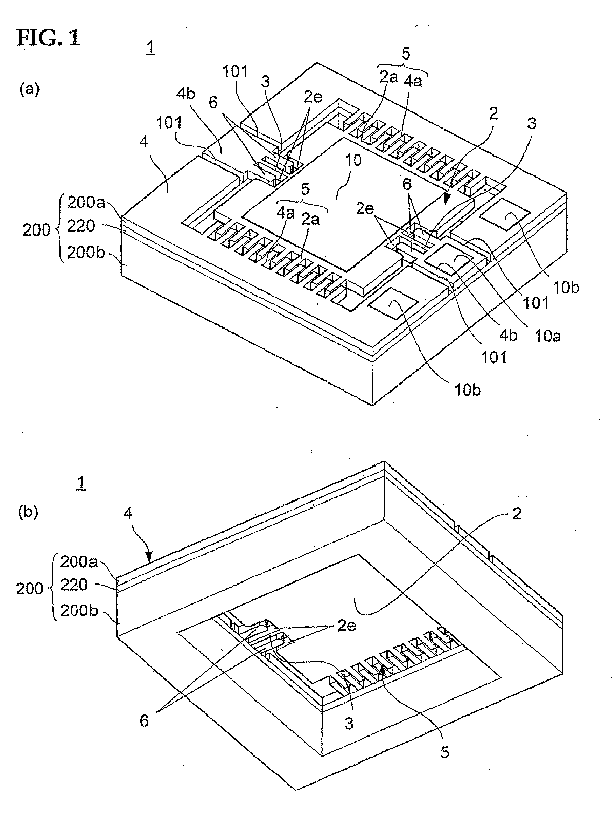

A first embodiment of the present invention is described below with reference to figures. FIGS. 1(a) and (b), FIG. 2 and FIG. 3 show an example of a light scanning mirror (a moving structure) in accordance with this embodiment. The light scanning mirror 1 is a miniature one which is to be mounted on an optical instrument such as a bar-code reader, a projector apparatus which projects an image on an external screen, or a light switch, and has a function to scan light beams which are incident from external light source or the like (not shown in the figures).

First, a configuration of the light scanning mirror 1 is described. The light scanning mirror 1 is a MEMS (Micro Electro Mechanical System) device manufactured by processing a SOI (Silicon on Insulator) substrate 200 using so-called micro machining technology. The SOI substrate 200 is a triple-layered substrate consisting of a first silicon layer (activation layer) 200a and a second silicon layer (substrate layer) 200b which are joined via a silicon oxidation film (BOX (Buried Oxide) layer) 220. Since the oxidation film 220 has electric insulation characteristic, the first silicon layer 200a and the second silicon layer 200b are electrically insulated each other. A thickness of the first silicon layer 200a is about 30µm, and a thickness of the second silicon layer 200b is about 400µm. As shown in FIG. 1(a), the light scanning mirror 1 is a rectangular solid device that a top face thereof is substantially square or substantially rectangular of about several mm in planar view.

The light scanning mirror 1 comprises a moving plate 2 having substantially a rectangular shape in planar view and a mirror face 10 formed on a top face thereof, twin hinges 3 which are respectively connected to both end portions of the moving plate 2 at an end of each and constitute an axis of swing motion of the moving plate 2, a stationary frame (frame) 4 disposed to surround peripheries of the moving plate 2 and to support other end portions of the hinges 3, comb tooth electrodes 5 having electrodes 2a at a part of the moving plate 2 and electrodes 4a at a part of the stationary frame 4, and stoppers 6 formed on the stationary frame 4. As shown in FIG. 1(b), a space is formed below the moving plate 2, and the moving plate 2 is supported through the hinges 3 to be swingable with respect to the stationary frame 4 around the hinges 3 serving as the axis of swing motion while twisting the twin hinges 3. The twin hinges 3 are formed so that an axis formed by them passes through a center of gravity of the moving plate 2 in planar view. A width dimension of the hinges 3 is about several µm to several tens µm, for example. Voltage application areas such as metal films 10a and 10b are formed on a top face of the stationary frame 4. Besides, the shapes of the moving plate 2 and the mirror face 10 are not limited to a rectangle, and, they may be a circle or an oval, for example. The light scanning mirror 1 is mounted on a circuit board B or the like so that a glass substrate 110 is joined to a bottom face of the stationary frame 4, for example.

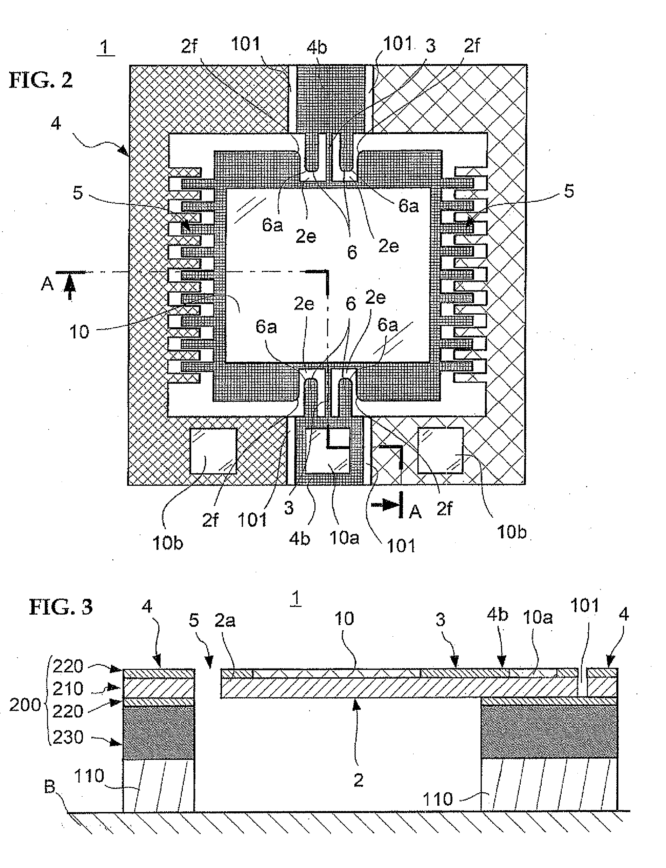

As shown in FIG. 3, the moving plate 2 and the hinges 3 are formed on the first silicon layer 200a. The mirror face 10 is a thin film made of aluminum, for example, and formed to reflect light beams incident to the top face of the moving plate 2 from outside. The moving plate 2 is formed substantially symmetrical shape with respect to a plane perpendicular to the moving plate 2 and passing through the hinges 3, and configured to swing smoothly around the hinges 3.

The stationary frame 4 is configured of the first silicon layer 200a, the oxidation film 220 and the second silicon layer 200b. In this embodiment, trenches 101 are formed on the stationary frame 4 so as to divide the first silicon layer 200a into three regions which are electrically insulated each other, for example. The trenches 101 are spaces formed to be channel shapes communicating top end to bottom end of the first silicon layer 200a to reach the oxidation film 220. Since the trenches 101 are formed only on the first silicon layer 200a, entire of the stationary frame 4 is formed integrally. The trenches 101 are formed at four places so that two supporting portions 4b respectively connected to the twin hinges 3 are electrically insulated from other portions of the stationary frame 4. The stationary frame 4 is divided into the two supporting portions 4b which are connected to the twin hinges 3 to be the same electric potential as that of the moving plate 2 and two portions on which the voltage application areas 10b are formed on the top face thereof by forming the trenches 101. Since the trenches 101 separate the first silicon layer 200a, these portions are electrically insulated each other. In other words, as shown by adding patterns to respective portions in FIG. 2, the moving plate 2, the hinges 3 and the stationary frame 4 are configured as three portions electrically insulated each other.

The electrodes 2a of the comb tooth electrodes 5 are formed in side end portions of the moving plate 2 serving as free ends where the hinges 3 are not connected, and the electrodes 4a are formed in portions of the stationary frame 4 facing the side end portions of the moving plate 2. The electrodes 2a and 4a constituting the comb tooth electrodes 5 are formed to engage with each other. Gaps between the electrodes 2a and 4a are about 2µm to 5µm.

The stoppers 6 are provided to restrain a quantity of displacement in a lateral direction of the moving plate 2, that is, in a direction substantially perpendicular to the axis of swing motion configured by the hinges 3 and substantially in parallel with the top face of the SOI substrate 200. As shown in FIG. 2, the stoppers 6 are formed integrally with the stationary frame 4 on the first silicon layer 200a and to protrude toward the moving plate 2 from the stationary frame 4 and along the hinges 3 at both sides of the hinges 3. In this embodiment, recesses 2e are formed in regions of the moving plate 2 where the hinges 3 are connected so as to hollow in a direction to depart from the stationary frame 4, that is, a longitudinal direction of the hinges 3. In other words, the hinges 3 are connected to inner end portions of the recesses 2e formed on the moving plate 2. The stoppers 6 are formed so that front ends of them near to the moving plate 2 are located between the hinges 3 and the side end portions of the moving plate 2 forming the recesses 2e. The stoppers 6 are formed to have predetermined gaps between the hinges 3 and them so as not to block the swing motion of the moving plate 2 in a normal state where no mechanical shock is applied to the light scanning mirror 1 from outside. Therefore, the hinges 3 is never broken by contacting the stoppers 6. The stoppers 6 are configured to protrude from the supporting portions 4b of the stationary frame 4 where the hinges 3 are connected, and thus, the moving plate 2, the hinges 3 and the stoppers 6 are configured to be the same electric potential.

As shown in FIG. 2, chamfers 6a formed to be round shape are provided at corners in the vicinity of the front ends of the stoppers 6. In addition, chamfers 2f formed to be round shape are provided at corners of the recesses 2e facing the stoppers 6. The stoppers 6 are formed so that gaps between the stoppers 6 and the recesses 2e of the moving plate 2 become narrower than gaps between the stoppers 6 and the hinges 3. In addition, sticking prevention films (not illustrated in the figures) are formed on portions of the stoppers 6 facing the moving plate 2. The sticking prevention films are provided by forming DLC (Diamond Like carbon) film or SAM (Self-assembled Monolayer) on the portions of the stoppers 6 facing the moving plate 2, for example.

Subsequently, motion of the light scanning mirror 1 which is configured as above is described. The moving plate 2 of the light scanning mirror 1 is driven when the comb tooth electrodes 5 generate driving forces at predetermined driving frequency. The comb tooth electrodes 5 are driven by applying voltages having a predetermined driving frequency between the electrodes 2a and 4a with periodically varying the electric potential of the voltage application area 10a which will be the same electric potential as that of the electrodes 4a under a state that the voltage application area 10a disposed in the supporting portion 4b is connected to the ground electric potential and the electrodes 2a of the moving plate 2 is at a reference electric potential, for example.
Two sets of the electrodes 2a provided in both end portions of the moving plate 2 are simultaneously gravitated to the electrodes 4a facing thereto by electrostatic force by varying the electric potentials of two sets of the electrodes 4a of the comb tooth electrodes 5 to predetermined driving electric potential (for example, several tens volts), simultaneously. In this light scanning mirror 1, it is configured that pulse voltages of rectangular waveforms, for example, are applied to the comb tooth electrodes 5, and the driving forces by the comb tooth electrodes 5 are periodically generated.

In this embodiment, the light scanning mirror 1 is configured to swing the moving plate 2 by electrostatic force as the driving force, for example. When the voltages are applied between the electrodes 2a and 4a periodically, electrostatic forces which act in directions to gravitate each other are generated between both of the electrodes 2a and 4a, and thus, the electrostatic forces act on the free ends of the moving plate 2 in directions substantially perpendicular to the top face of the moving plate 2. In other words, a torque around the hinges 3 is generated in the moving plate 2 by the electrostatic forces, when driving voltages are applied to the comb tooth electrodes 5 from outside by varying the electric potentials of the voltage application areas 10a and 10b.

In such light scanning mirror 1, the moving plate 2 does not take level posture and inclines a little in a state of rest due to occurrence of internal stresses or the like at the time of forming in many cases, generally. Therefore, when the comb tooth electrodes 5 are driven from the state of rest, the driving forces act on the moving plate 2 in the direction substantially perpendicular to it, and thus, the moving plate 2 rotates around the hinges 3 serving as the rotation axis. Subsequently, when the posture of the moving plate 2 becomes in parallel with the stationary frame 4, that is, in a state that the electrodes 2a and the electrodes 4a completely overlap each other in side view, the driving forces of the comb tooth electrodes 5 are released, so that the moving plate 2 continues to rotate while twisting the hinges 3 by inertia force thereof. When the inertia force of the moving plate 2 in a rotational direction becomes equal to the restitution forces of the hinges 3, the rotation of the moving plate 2 in the direction stops. At this time, the comb tooth electrodes 5 are driven again, and the moving plate 2 starts to rotate in the opposite direction by the restitution forces of the hinges 3 and the driving forces of the comb tooth electrodes 5. The moving plate 2 is swung by repeating such rotations due to the driving forces of the comb tooth electrodes 5 and the restitution forces of the hinges 3. The comb tooth electrodes 5 are driven by applying the voltages having a frequency about two times as large as a resonance frequency of a vibration system configured of the moving plate 2 and the hinges 3, and the moving plate 2 is configured to be driven with resonance phenomenon so as to enlarge the swing angle thereof. Besides, since application manner and frequency of the voltages to the comb tooth electrodes 5 are not limited to the above mentioned cases, it may be configured that the driving voltages are applied as sinusoidal wave forms, or it may be configured that the electric potentials of the electrodes 2a and 4a are varied in opposite phases each other.

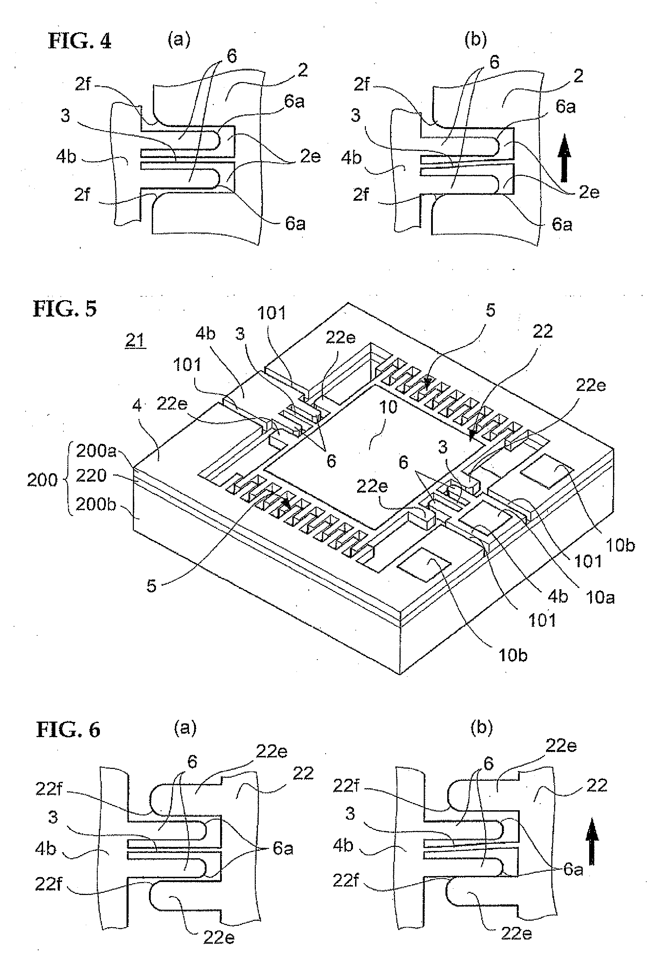

Hereupon, the light scanning mirror 1 has high crashworthy because the stoppers 6 are provided in comparison with the case that no stopper 6 is provided. FIGS. 4(a) and (b) respectively show a region of the light scanning mirror 1 in the vicinity of the stoppers 6. In a normal state where no mechanical shock or the like is applied from outside, the hinges 3 are rarely bent and it is in a state that gaps are formed between the stoppers 6 and the moving plate 2, as shown in FIG. 4(a). At this time, when vibrations or a mechanical shock are/is applied to the light scanning mirror 1 from outside, the moving plate 2 may displace in lateral direction (shown by black arrow in the figure) from the normal state while deforming the hinge 3, as shown in FIG. 4(b). When a quantity of the displacement becomes much larger, the stopper 6 contacts the side end portion of the recess 2e, so that the displacement of the moving plate 2 in the direction is restrained, and thus, quantities of deformations of the hinges 3 may not be increased no more. In addition, the hinges 3 do not contact the stoppers 6 while the moving plate 2 displaces from the normal state to a time when the stopper 6 contacts the side end portion of the recess 2e.

In addition, the light scanning mirror is manufactured by processes as follows, for example. First, a SOI substrate 200 is formed by forming an oxidation film 220 on a first silicon layer 200a and attaching a second silicon layer 200b thereon. Subsequently, shapes which will be the moving plate 2, the hinges 3, the stationary frame 4, the comb shaped electrodes 5 and the stoppers 6 are formed on the first silicon layer 200a side of the SOI substrate 200 by so-called bulk micro machining technology such as photolithography, or etching (first process). In this way, each portion of the light scanning mirror 1 including minute shape can be formed easily by using the bulk micro machining technology. Subsequently, a metal film is formed on a top face of the first silicon layer 200a of the SOI substrate 200 using sputtering method or the like. A mirror face 10 is formed on the moving plate 2 and voltage application areas 10a and 10b are formed on a top face of the stationary frame 4 by pattering this metal film.

Subsequently, a shape which will be the stationary frame 4 is formed on the second silicon layer 220b by processing of the the bulk micro machining technology, similarly (second process). Etching of the oxidation film 220 is performed after processing the first silicon layer 200a and the second silicon layer 200b. Regions of the oxidation film 220 other than the stationary frame 4 are removed by performing the etching process from below the light scanning mirror 1, for example (third process). Thereby, the moving plate 2 becomes a swingable state with respect to the stationary frame 4 by being pivoted on the stationary frame 4 through the hinges 3. A plurality of the light scanning mirrors 1 are formed on the SOI substrate 200 by passing the above mentioned first process to third process. After the third process, a plurality of the light scanning mirrors 1 formed on the SOI substrate is individually cut out. By these series of processes, a plurality of the light scanning mirrors 1 are manufactured simultaneously, so that it is possible to decrease the manufacturing cost of the light scanning mirrors 1. Besides, the manufacturing processes of the light scanning mirror 1 are not limited to these, and it is possible to be formed by laser process, ultrasonic wave process or the like, and it may be formed one by one. In addition, the processing of the second silicon layer 200b may be performed prior to the processing of the first silicon layer 200a.

As mentioned above, since the moving plate 2 displaces not so large, and thus, breakage of the hinges 3 can be prevented by providing the stoppers 6 in this embodiment, it is possible to enhance crashworthy of the light scanning mirror 1. Since the stoppers 6 are disposed in the vicinities of the hinges 3, even when the moving plate 2 inclines with respect to the stationary frame 4, it is possible to restrain the displacement of the moving plate 2 in the lateral direction effectively, and to prevent the breakages of the hinges 3 surely. At this time, since the stoppers 6 do not contact the hinges 3, it is possible to prevent the breakage of the hinges 3 surely. In addition, since the moving plate 2 is pivoted by the hinges 3, it is hard to displace in a longitudinal direction of the axis of swing motion configured by the hinges 3. Therefore, a quantity of the displacement of the moving plate 2 in an in-plane direction in parallel with the top face of the SOI substrate 200 can be restrained substantially completely by providing the stoppers 6, and thus, it is possible to prevent the breakage of the hinges 3 effectively. In addition, since the stoppers 6 are supported by the recesses 2e in the displacement of the moving plate 2, it is possible to constitute a strong structure for supporting the stoppers 6 easily. Still furthermore, the chamfers 6a are formed on the stoppers 6 so that the portions which may contact the side end portions of the recesses 2e are not aculeate, and similarly, the chamfers 2f are formed at side end portions of the recesses 2e so that the portions which may contact the stoppers 6 are not aculeate. Therefore, it is hard to concentrate the stress to the contacting portions of the stopper 6 and the side end portion of the recess 2e, so that it is possible to prevent breakage of the stoppers 6 and the moving plate 2.

Furthermore, the stoppers 6 and the side end portions of the recesses 2e are at the same electric potential, and the sticking prevention films are formed on the portions of the stoppers 6 which may contact the side end portions of the recesses 2e. Therefore, even when the stopper 6 contacts the recess 2e, sticking due to electrostatic force hardly occurs, and thus, it is possible to prevent that the moving plate 2 becomes immovable, surely. Still furthermore, it is sufficient that the stoppers 6 are provided at sides of the hinges 3 not to block the swing motion of the moving plate 2 but to contact the recesses 2e of the moving plate 2 when the moving plate 2 displaces in the lateral direction, so that positioning of the stoppers 6 is not performed accurately, and thus, the light scanning mirror 1 can be manufactured relatively easier. In particular, since the stoppers 6 can be formed simultaneously in the processes to form the stationary frame 4 by processing the first silicon layer 200a in this embodiment, proper gaps between the stoppers 6 and the stationary frame 4 can be assured and it is easily manufactured.

### (Second Embodiment)

Subsequently, a second embodiment of the present invention is described. FIG. 5 shows a light scanning mirror 21 in accordance with the second embodiment. Hereinafter, elements similar to those in the above mentioned first embodiment are designated by the same reference marks, and only the portions different from the above first embodiment are described. The light scanning mirror 21 has a moving plate 22 of a different shape from the moving plate 2 of the light scanning mirror 1. In other words, as shown in the figure, the moving plate 22 has no recess 2e but has contacting protrusions 22e formed to protrude toward the stationary frame 4 respectively at positions distant much farther from the hinges 3 than the stoppers 6 at both side portions of the hinges 3. Other configurations of the moving plate 22 and a configuration of the light scanning mirror 21 other than the moving plate 22 are similar to those of the light scanning mirror 1 in the first embodiment. This light scanning mirror 21 can be manufactured easily by forming the shapes including the contacting protrusions 22e on the first silicon layer 200a by processing the bulk micro machining technology.

FIGS. 6(a) and (b) respectively show a region of the light scanning mirror 21 in the vicinity of the stoppers 6. The two contacting protrusions 22e are respectively disposed at positions nearer to the sides of the stoppers 6 near to the hinges 3 than the contacting protrusions 22e. As shown in FIG. 6(a), it is configured that gaps between the stoppers 6 and the contacting protrusions 22e are a little narrower than gaps between the stoppers 6 and the hinges 3 in the normal state. In addition, chamfers 22f of round shape are formed at corners of the contacting protrusions 22e at the sides of the stoppers 6. When the moving plate 2 displaces in a lateral direction as shown in FIG. 6(b), one of the stoppers 6 contacts the contacting protrusion 22e, so that the moving plate 22 displaces no more. Therefore, it is possible to prevent the breakages of the hinges 3 and to enhance the crashworthy of the light scanning mirror 21 in this embodiment similar to the above mentioned first embodiment. Since the stoppers 6 do not contact the hinges 3, it is possible to prevent the breakage of the hinges 3 surely. Since the stoppers 6 and the contacting protrusions 22e are at the same electric potential, even when the stopper 6 contacts the contacting protrusion 22e, sticking hardly occurs, and thus, it is possible to maintain the light scanning mirror 21 in movable state surely.

### (Third Embodiment)

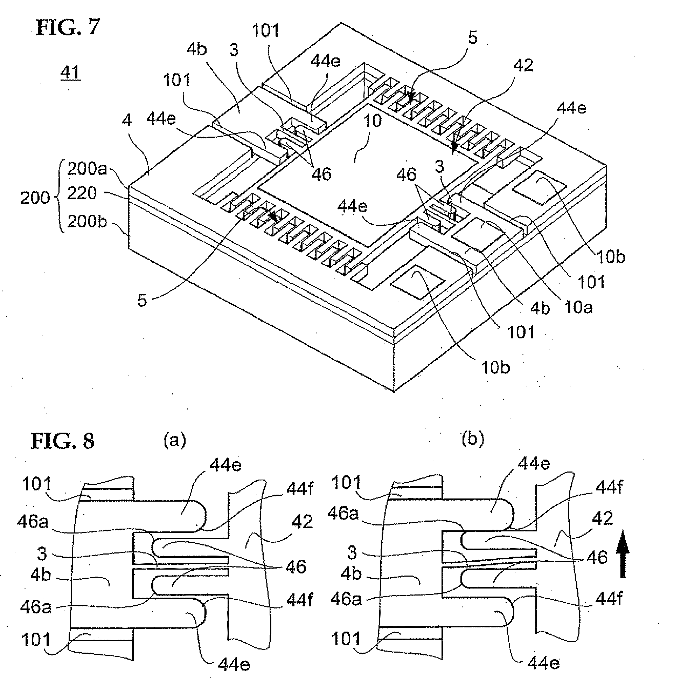

FIG. 7 shows a light scanning mirror 41 in accordance with a third embodiment of the present invention. The light scanning mirror 41 comprises a moving plate 42 having stoppers 46 formed along the hinges 3 replacing with the moving plate 2 of the light scanning mirror 1. In addition, contacting protrusions 44e are formed at the supporting portions 4b of the stationary frame 4. The contacting protrusions 44e are respectively formed to protrude toward the moving plate 42 at positions at both sides of the hinges 3 and distant farther from the hinges 3 than the stoppers 46. The configurations of the light scanning mirror 42 other than the moving plate 42 and the contacting protrusions 44e are similar to those of the light scanning mirror 1 in the first embodiment. This light scanning mirror 41 can be manufactured easily by forming the shapes including the moving plate 42 and the contacting protrusions 44e on the first silicon layer 200a by processing the bulk micro machining technology.

FIGS. 8(a) and (b) respectively show a region of the light scanning mirror 41 in the vicinity of the stoppers 46. Two of the contact protrusions 44e are respectively disposed at positions near to the sides of the stoppers 46 nearer to the hinges than the contacting protrusions 44e. As shown in FIG. 8(a), it is configured that gaps between the stoppers 46 and the contacting protrusions 44e are a little narrower than gaps between the stoppers 46 and the hinges 3 in the normal state. Chamfers 44f and chamfers 46a are formed on the contacting protrusions 44e and the stoppers 46 respectively, similar to the chamfers 2f for the recesses 2e and the chamfers 6a of the stoppers 6 of the light scanning mirror 1. As shown in FIG. 8(b), when the moving plate 42 displaces in a lateral direction, one of the stoppers 46 contacts the contacting protrusion 44e, so that the moving plate 42 displaces no more. Therefore, it is possible to prevent the breakages of the hinges 3 and to enhance the crashworthy of the light scanning mirror 41 in this embodiment similar to the above mentioned first embodiment or the second embodiment. Since the stoppers 46 do not contact the hinges 3, it is possible to prevent the breakage of the hinges 3 surely. Still furthermore, since the chamfers 44f are formed on the contacting protrusions 44e and the chamfers 46a are formed on the stoppers 46, it is possible to prevent the breakage of the stoppers 46 or the contacting protrusions 44e.

### (Fourth Embodiment)

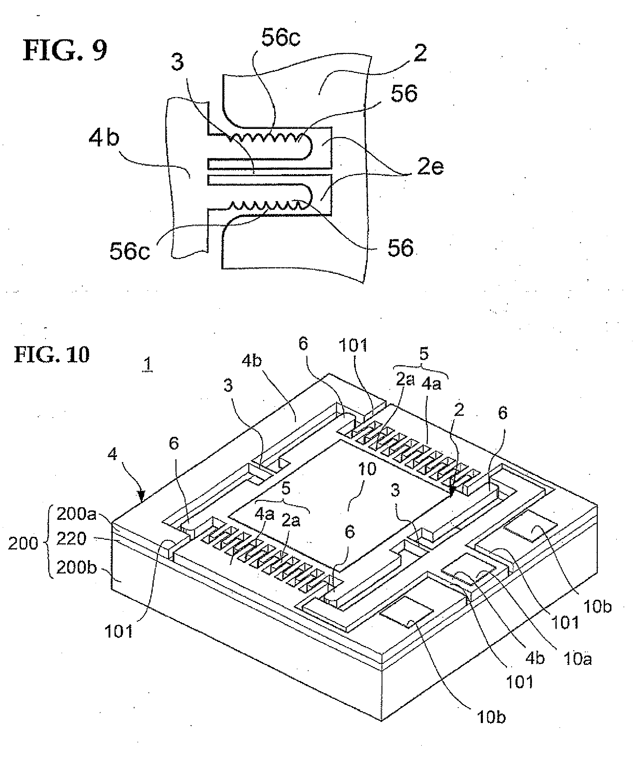

FIG. 9 shows a region of a light scanning mirror in the vicinity of the stoppers 56 in accordance with a fourth embodiment of the present invention. In the forth embodiment, entire configuration of the light scanning mirror is similar to that of the light scanning mirror 1 in the first embodiment, so that description of it is omitted. In the fourth embodiment, the stoppers 56 to which convexities 56c are formed are provided replacing with the stoppers 6 to which the sticking prevention films are formed. As shown in the figure, the convexities 56c are provided to form saw tooth at positions of the stoppers 56 contacting to side end portions of the recesses 2e when the moving plate 2 displaces in planar view, for example.

In the fourth embodiment, since the convexities 56c are provided on the stoppers 56, when the stopper 56 and the side end portion of the recess 2e contact, contacting areas of each other become smaller. Thereby, affection of electrostatic forces between the stopper 56 and the recess 2e becomes smaller, so that occurrence of sticking can be prevented. In addition, shapes of the convexities 56c are not limited to the saw tooth shapes. The convexities 56c are preferably formed to have shapes not to concentrate stress to contacting portions too much when the stopper 56 contacts the recess 2e. Still furthermore, it is preferable to form sticking prevention films at positions of the stoppers 56 contacting the side end portions of the recesses 2e in the fourth embodiment, so that occurrence of sticking can be prevented surely.

In addition, in the first embodiment to the fourth embodiment, the present invention is not limited to the configurations of the above mentioned embodiments, it is possible to modify in various manner in the scope not to change the purpose of the invention. The light scanning mirror is not limited to one which can swing around a single axis as described in the above mentioned embodiments, but it may be a biaxial gimbals type having a moving frame (frame) swingably pivoted on a stationary frame, and a mirror to which a mirror face is formed is swingably pivoted on the moving frame, for example. In this case, displacement of a moving plate including the moving frame and the mirror can be restrained by forming stoppers along hinges by which the moving frame is pivoted. Similarly, displacement of the mirror serving as the moving plate with respect to the moving frame can be restrained by forming stoppers along hinges by which the mirror is pivoted. Furthermore, the light scanning mirror may be configured of a single silicon substrate or a metal plate instead of the SOI substrate, and driving forces to swing the moving plate may be electrostatic forces acting between flat electrodes, electromagnetic forces, electrostriction forces or heatstriction forces instead of the electrostatic forces acting between comb tooth electrodes. Still furthermore, the stoppers may not be formed integrally with the moving plate or the frame, and it may be disposed at positions distant from the moving plate or the frame if it enables to restrain the displacement of the moving plate. In any case, it is possible to restrain the displacement of the moving plate in the lateral direction, to prevent the breakage of the hinges and to enhance the crashworthy of the light scanning mirror by forming the stoppers along the hinges at positions in sides of the hinges which support the moving plate.

Still furthermore, the present invention is not limited to a light scanning mirror having a mirror face to scan light, and it is widely applicable to a moving structure that a moving plate which is configured swingable with respect to a stationary frame by twin hinges is formed on a semiconductor substrate. In other words, it is possible to enhance crashworthy of the moving structure by providing stoppers along the hinges at positions in sides of the hinges.

### (Fifth embodiment)

A fifth embodiment of the present invention is described below with reference to the figures. FIG. 10, FIG. 11 and FIG. 12 show an example of a light scanning mirror (moving structure) in accordance with the embodiment.

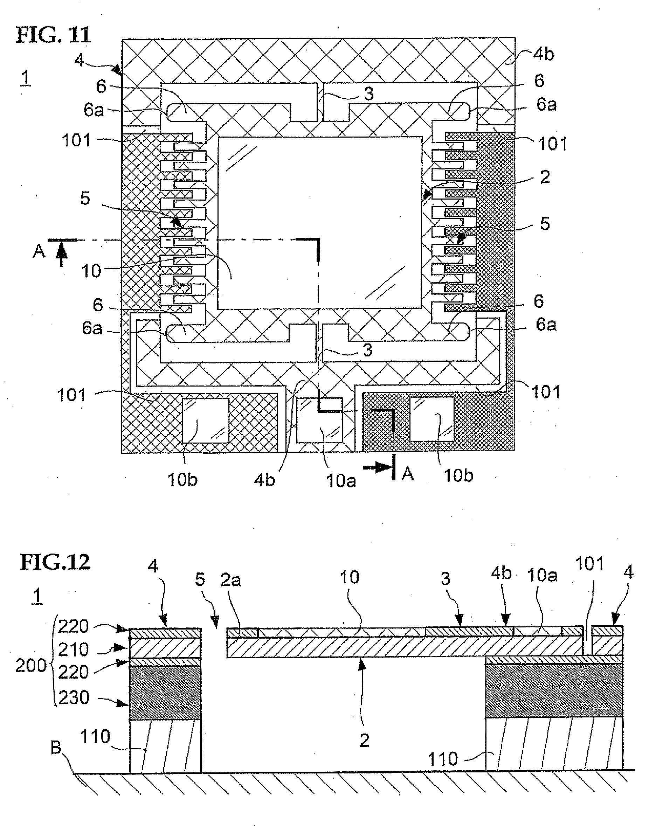

The light scanning mirror 1 comprises a moving plate 2 having substantially a rectangular shape in planar view and a mirror face 10 formed on a top face thereof, twin hinges 3 which are respectively connected to both end portions of the moving plate 2 at an end of each and constitute an axis of swing motion of the moving plate 2, a stationary frame (frame) 4 disposed to surround peripheries of the moving plate 2 and to support other end portions of the hinges 3, comb tooth electrodes 5 having electrodes 2a at a part of the moving plate 2 and electrodes 4a at a part of the stationary frame 4, and stoppers 6 formed on the moving plate 2. As shown in FIG. 12, a space is formed below the moving plate 2, and the moving plate 2 is supported through the hinges 3 so as to be swingable with respect to the stationary frame 4 around the hinges 3 serving as the axis of swing motion while twisting the twin hinges 3. The twin hinges 3 are formed so that an axis formed by them passes through a center of gravity of the moving plate 2 in planar view. A width dimension of the hinges 3 is about several µm to several tens µm, for example. Voltage application areas such as metal films 10a and 10b are formed on a top face of the stationary frame 4. In addition, the shapes of the moving plate 2 and the mirror face 10 are not limited to a rectangle, and, it may be a circle or an oval, for example. The light scanning mirror 1 is mounted on a circuit board B or the like so that a glass substrate 110 is joined on a lower face of the stationary frame 4, for example.

As shown in FIG. 12, the moving plate 2 and the hinges 3 are formed on a first silicon layer 200a. The mirror face 10 is a thin film made of aluminum, for example, and formed to reflect light beams incident to the top face of the moving plate 2 from outside. The moving plate 2 is formed substantially symmetrical shape with respect to a plane perpendicular to the moving plate 2 and passing through the hinges 3, and configured to swing smoothly around the hinges 3.

The stationary frame 4 is configured of the first silicon layer 200a, an oxidation film 220 and a second silicon layer 200b. In this embodiment, trenches 101 are formed on the stationary frame 4 so as to divide the first silicon layer 200a into three portions which are electrically insulated each other, for example The trenches 101 are spaces formed to be channel shapes communicating a top ends to a bottom end of the first silicon layer 200a to reach the oxidation film 220. Since the trenches 101 are formed only on the first silicon layer 200a, entire of the stationary frame 4 is formed integrally. The trenches 101 are formed at four positions at the sides of the two sets of the comb tooth electrodes 5 so that two supporting portions 4b respectively connected to the twin hinges 3 are electrically insulated from other portions of the stationary frame 4. The two supporting portions 4b are formed to be placed in regions facing peripheries of the moving plate 2 other than the regions where the electrodes 2a are formed, as described later.

In this way, by forming the trenches 101, the stationary frame 4 is divided into the two supporting portions 4b which is to be at the same electric potential of the moving plate 2 connected to the twin hinges 3 and to which a voltage application area 10a is formed on a top face thereof and two portions which has the electrodes 4a and to which voltage application areas 10b are formed on top faces thereof. Since the trenches 101 divides the first silicon layer 200a, these portions are electrically insulated each other. In other words, as shown by adding patterns to respective portions in FIG. 11, the moving plate 2, the hinges 3 and the stationary frame 4 are configured by three portions electrically insulated each other.

The electrodes 2a of the comb tooth electrodes 5 are formed in side end portions of the moving plate 2 serving as free ends where the hinges 3 are not connected, and the electrodes 4a are formed in portions of the stationary frame 4 facing the side end portions of the moving plate 2. The electrodes 2a and the electrodes 4a respectively have many comb tooth. Each comb teeth of the electrodes 2a and the electrodes 4a is formed to be thinner for enabling to arrange them as much as possible in a limited space to provide the comb tooth electrodes 5. Gaps between the electrodes 2a and 4a are about 2µm to 5µm.

The stoppers 6 are provided to restrain a quantity of displacement of the moving plate 2 in a lateral direction, that is, in a direction substantially perpendicular to an axis of swing motion configured by the hinges 3 and substantially in parallel with the top face of the SOI substrate 200. As shown in FIG. 11, the stoppers 6 are formed integrally with the moving plate 2 on the first silicon layer 200a. In this embodiment, the stoppers 6 are formed to protrude at four corners of the moving plate 2 positioned outside in arranging direction of the comb tooth electrodes 5 toward the stationary frame 4 facing the corresponding regions of the moving plate 2. The stoppers 6 are formed so that front ends of them near to the stationary frame 4 adjoin the supporting portions 4b of the stationary frame 4. The stoppers 6 are formed not to block the swing motion of the moving plate 2 in a normal state where no mechanical shock is applied to the light scanning mirror 1 from outside. The stoppers 6 are configured to protrude toward the regions of the supporting portions 4b of the stationary frame 4 arranged in parallel with the hinges 3, and, the moving plate 2, the hinges 3 and the stoppers 6 become the same electric potential.

As shown in FIG. 11, chamfers 6a formed to be round shape are provided at corners in the vicinity of the front ends of the stoppers 6. The stoppers 6 are formed so that gaps between the stoppers 6 and the supporting portions 4b become narrower than gaps between the electrodes 2a and the stationary frame 4 and gaps between the electrodes 4a and the moving plate 2. In addition, sticking prevention films (not illustrated in the figures) are formed on regions of the stoppers 6 facing the moving plate 2. The sticking prevention films are provided by forming DLC (Diamond Like carbon) film or SAM (Self-assembled Monolayer) on the regions of the stoppers 6 facing the moving plate 2, for example.

Since the motion of the light scanning mirror 1 in accordance with the fifth embodiment is equivalent to that of the light scanning mirror 1 in accordance with the first embodiment, description of it is omitted. In addition, since the manufacturing processes of the light scanning mirror 1 in accordance with the fifth embodiment is equivalent to those of the light scanning mirror 1 in accordance with the first embodiment, description of it is omitted.

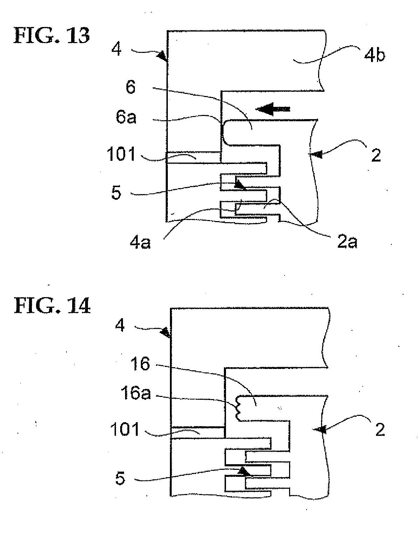

The light scanning mirror 1 in accordance with the fifth embodiment has high crashworthy because the stoppers 6 are provided in comparison with the case that no stopper 6 is provided. FIG.13 shows a region of the light scanning mirror 1 in the vicinity of the stoppers 6. In a normal state where no mechanical shock or the like is applied to the light scanning mirror 1 from outside, it is in the state that gaps are formed between the stoppers 6 and the supporting portions 4b facing thereto. At this time, when vibrations or a mechanical shock are/is applied to the light scanning mirror 1 from outside, the moving plate 2 may displace in a lateral direction (shown by arrow in the figure) from the normal state, that is, the direction substantially perpendicular to the axis of the swing motion and substantially in parallel with the top face of the SOI substrate 200 while deforming the hinge 3, as shown in the figure. When a quantity of the displacement of the moving plate 2 in the lateral direction becomes larger, the stopper 6 contacts a side end portion of the supporting portion 4b, so that the displacement of the moving plate 2 in the direction is restrained, and thus, the quantity of the displacement may not be increased no more. In a state that the stopper 6 contacts the side end portion of the supporting portion 4b, the comb tooth of the electrodes 2a do not contact the stationary frame 4 and the comb tooth of the electrodes 4a do not contact the moving plate, so that the comb tooth electrodes 5 are protected.

In addition, the light scanning mirror 1 is manufactured by processes as follows, for example. First, a SOI substrate 200 is formed by forming an oxidation film 220 on a first silicon layer 200a and attaching a second silicon layer 200b thereon. Subsequently, shapes which will be the moving plate 2, the hinges 3, the stationary frame 4, the comb shaped electrodes 5 and the stoppers 6 are formed on the first silicon layer 200a side of the SOI substrate 200 by so-called bulk micro machining technology such as photolithography, or etching (first process). In this way, each portion of the light scanning mirror 1 including minute shape can be formed easily by using the bulk micro machining technology. Subsequently, a metal film is formed on a top face of the first silicon layer 200a of the SOI substrate 200 using sputtering method or the like. The mirror face 10 is formed on a top face of the moving plate 2 and the voltage application areas 10a and 10b are formed on a top face of the stationary frame 4 by pattering the metal film.

Subsequently, a shape which will be the stationary frame 4 is formed on the second silicon layer 220b by processing the bulk micro machining technology, similarly (second process). Etching of the oxidation film 220 is performed after processing the first silicon layer 200a and the second silicon layer 200b. A part of the oxidation film 220 other than the stationary frame 4 is removed by performing the etching process from below the light scanning mirror 1, for example (third process). Thereby, the moving plate 2 becomes a swingable state with respect to the stationary frame 4 by being pivoted on the stationary frame 4 through the hinges 3. A plurality of the light scanning mirrors 1 are formed on the SOI substrate 200 by passing the above mentioned first process to third process. After the third process, a plurality of the light scanning mirrors 1 formed on the SOI substrate is individually cut out. By these series of processes, a plurality of the light scanning mirrors 1 are manufactured simultaneously, so that it is possible to decrease the manufacturing cost of the light scanning mirrors 1. In addition, the manufacturing processes of the light scanning mirror 1 are not limited to these, and it is possible to be formed by laser process, ultrasonic wave process or the like, and it may be formed one by one. In addition, the processing of the second silicon layer 200b may be performed prior to the processing of the first silicon layer 200a.

As mentioned above, since the displacement of the moving plate 2 is restrained, and thus, the breakage of the comb tooth electrodes 5 can be prevented by providing the stoppers 6 in this embodiment, the crashworthy of the light scanning mirror 1 can be enhanced. In addition, since the moving plate 2 is pivoted by the hinges 3, it is hard to displace in a longitudinal direction of the axis of swing motion configured by the hinges 3. Therefore, a quantity of the displacement of the moving plate 2 in an in-plane direction in parallel with the top face of the SOI substrate 200 can be restrained substantially completely by providing the stoppers 6, and thus, it is possible to prevent the breakage of the comb tooth electrodes 5 effectively. In addition, the chamfers 6a of round shape are formed on the stoppers 6 and there is no aculeate shape in the portion contacting to the stationary frame 4, so that it is hard to concentrate stress to the contacting portions of the stoppers 6 and the stationary frame 4, and it is possible to prevent the breakage of the stoppers 6 or the stationary frame 4.

Furthermore, the stoppers 6 and the supporting portions 4b of the stationary frame 4 are at the same electric potential, and the sticking prevention films are formed on the regions of the stoppers 6 which may contact the supporting portions 4b. Therefore, even when the stopper 6 contacts the supporting portion 4b, sticking due to electrostatic force hardly occurs, and thus, it is possible to prevent that the moving plate 2 becomes immovable, surely. Still furthermore, since the stoppers 6 can be formed integrally with the moving plate 2, the light scanning mirror 6 can be manufactured relatively easily. In particular, since the stoppers 6 are formed simultaneously in the processes to form the moving plate 2 by processing the first silicon layer 200a, proper gaps between the stoppers 6 and the stationary frame 4 can be assured and it is easily manufactured.

In addition, in the fifth embodiment, it is possible to prevent the occurrence of sticking by forming convexities on the stoppers. FIG. 14 shows an example of the stopper having the convexities. Saw tooth shaped convexities 16a are formed at a portion of the stopper 16 which may contact the stationary frame 4 when the moving plate 2 displaces in the lateral direction. In this way, since the convexities 16a are formed on the stopper 16, when the stopper 16 contacts the stationary frame 4, contacting areas of them become smaller. Thereby, since affect of electrostatic force between the stopper 16 and the stationary frame 4 becomes smaller, occurrence of sticking can be prevented. In addition, the shapes of the convexities 16a are limited to the saw tooth shapes. The convexities 16a are preferably formed to have shapes not to concentrate stresses to contacting portions when the stopper 16 contacts the stationary frame 4. Furthermore, it is preferable to form sticking prevention films at portions of the stoppers 16 contacting the stationary frame 4 when the convexities 16a are formed on the stopper 16, so that occurrence of sticking can be prevented surely.

### (Sixth Embodiment)

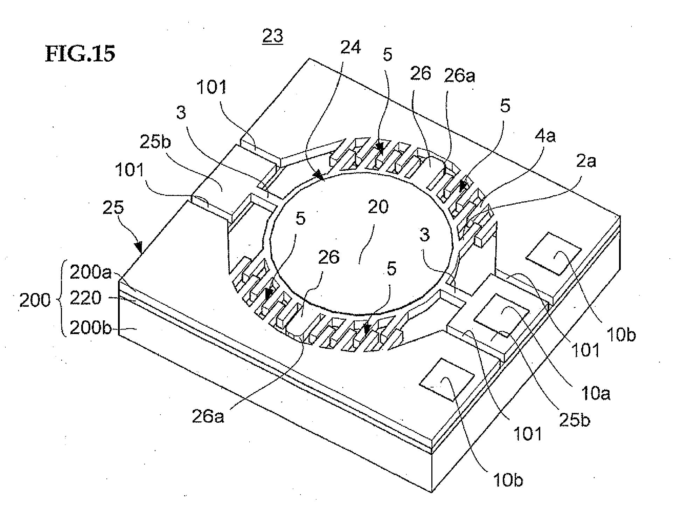

Subsequently, a sixth embodiment of the present invention is described. FIG. 15 shows a light scanning mirror 23 in accordance with the sixth embodiment. Hereinafter, elements similar to those in the above fifth embodiment are designated by the same reference marks, and only the portions different from the above mentioned first (SIC: correctly, it should be fifth) embodiment are described. The light scanning mirror 23 has a moving plate 24 of a circular shape and a stationary frame 25 formed to surround the moving plate 24, and two stoppers 26 respectively formed at substantially center areas of the free end portions of the moving plate 24. Although the stationary frame 25 is divided into three portions which are electrically insulated each other by forming trenches 101, the stationary frame 4 (SIC: correctly, it should be 25) facing the stoppers 26 is not at the same electric potential as that of the stoppers 26, different from the first (SIC: correctly, it should be fifth) embodiment. Supporting portions 24b (SIC: correctly, it should be 25b) of the stationary frame 25 are disposed at regions to support the hinges 3 and not placed at regions to face the moving plate 24. In addition, regions of the stationary frame 4 (SIC: correctly, it should be 25) facing the stoppers 26 may be at the same potential as that of the stoppers 26 by changing the arrangement of the trenches 101 and voltage application areas 10b. Other configurations of the light scanning mirror 23 are similar to that of the light scanning mirror 1 in the first (SIC: correctly, it should be fifth) embodiment. This light scanning mirror 23 can be manufactured easily by forming the shapes that the stoppers 26 are provided on the moving plate 24 on the first silicon layer 200a by processing the bulk micro machining technology.

As shown in the figure, the comb tooth electrodes 5 are arranged along the end portions of the moving plate 24 at both sides of the stoppers 25 formed at the substantially center portions of the free ends of the moving plate 24. In other words, the stoppers 26 are disposed in the vicinities of the sides of the comb tooth electrodes 5. Similar to the first (SIC: correctly, it should be fifth) embodiment, the stoppers 26 are formed so that gaps to the stationary frame 25 and them are a little narrower than gaps between the electrodes 2a of the comb tooth electrodes 5 and the stationary frame 25 or gaps between the electrodes 4a and the moving plate 24 in the normal statue. In addition, sticking prevention films are formed at regions of the stopper 26 contacting the stationary frame 25 and chamfers 26a of round shape are formed at corners thereof.

In the sixth embodiment, even when vibrations or a mechanical shock are/is applied from outside, one of the stoppers 26 contacts the stationary frame 25, and thus, the moving plate 24 displaces no more. Therefore, in this embodiment, it is possible to prevent the breakage of the comb tooth electrodes 5 and to enhance the crashworthy of the light scanning mirror 23 similar to the above first (SIC: correctly, it should be fifth) embodiment. Since the sticking prevention films are formed on the stoppers 26, sticking hardly occurs when the stopper 26 contacts the stationary frame 25. In addition, since the chamfers 26a are formed on the stoppers 26, it is possible to prevent the breakage of the stoppers 26 and the stationary frame 25.

In addition, in the fifth embodiment and the sixth embodiment, the present invention is not limited to the configurations of the above embodiments, and it is possible to modify in various manner properly in a scope not to change the purpose of the invention. For example, the stoppers are not limited to be formed integrally with the moving plate, and they may be formed integrally with the stationary frame so as to protrude toward the moving plate from the stationary frame in the vicinity of the comb tooth electrodes. Even in this case, when the moving plate displaces in the lateral direction, the stopper contacts the moving plate so that the quantity of the displacement of the moving plate is restrained, and thus, the comb tooth electrodes can be protected.

Furthermore, the light scanning mirror is not limited to one which can swing around a single axis as described in the above embodiments, but it may be a biaxial gimbals type having a moving frame (frame) swingably pivoted on a stationary frame, and a mirror to which a mirror face is provided is swingably pivoted on the moving frame, for example. In this case, by disposing stoppers in the vicinities of comb tooth electrodes between the moving frame and the stationary frame, a quantity of the displacement of the moving plate including the moving frame and the mirror can be restrained and the comb tooth electrodes can be protected. Similarly, by forming stoppers in the vicinities of comb tooth electrodes between the mirror and the moving frame, a quantity of displacement of the mirror serving as the moving plate with respect to the moving frame can be restrained and the comb tooth electrodes can be protected. Furthermore, the light scanning mirror may be configured of a single silicon substrate or a metal plate instead of the SOI substrate. Still furthermore, the stoppers may not be formed integrally with the moving plate or the frame, and it may be disposed at positions distant from the moving plate or the frame if it enables to restrain the displacement of the moving plate. In this case, it is possible to restrain the displacement of the moving plate in the lateral direction, to prevent the breakage of the comb tooth electrodes and to enhance the crashworthy of the light scanning mirror by forming the stoppers in the vicinities of the comb tooth electrodes between the moving plate and the frames surrounding it.

Still furthermore, the present invention is not limited to the light scanning mirror having the mirror face to scan light, and it is widely applicable to a moving structure that a moving plate which is configured to swingable with respect to the stationary frame by twin hinges is formed on a semiconductor substrate. In other words, it is possible to enhance the crashworthy of the moving structure by providing the stoppers in the vicinities of the comb tooth electrodes between the moving plate and the frame.

### (Seventh Embodiment)

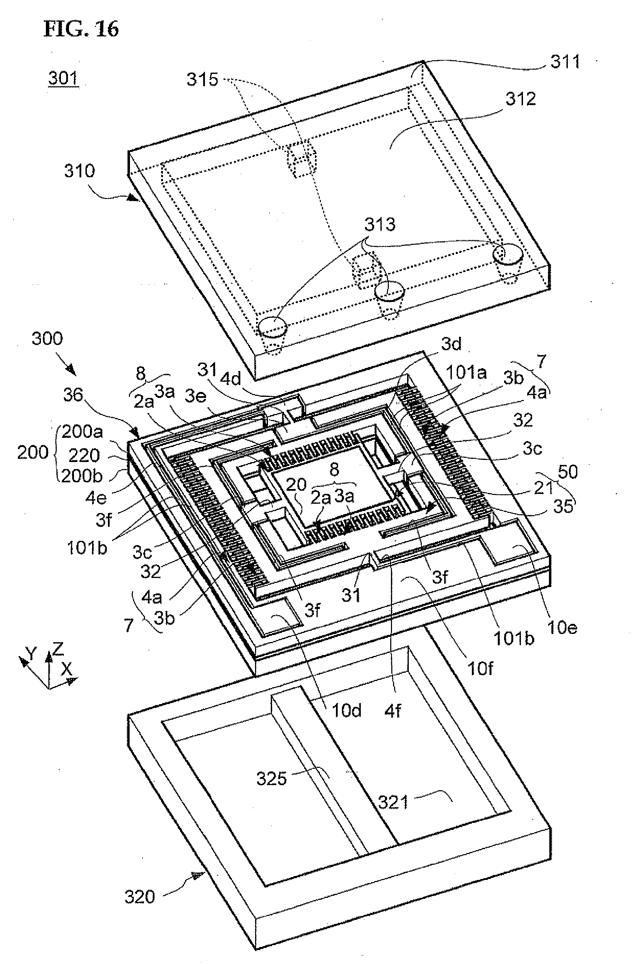

A seventh embodiment of the present invention is described below with reference to figures. FIG. 16, FIGS. 17(a) and (b) and FIG. 18 show an example of a light scanning mirror (semiconductor mechanical structure) in accordance with the seventh embodiment.

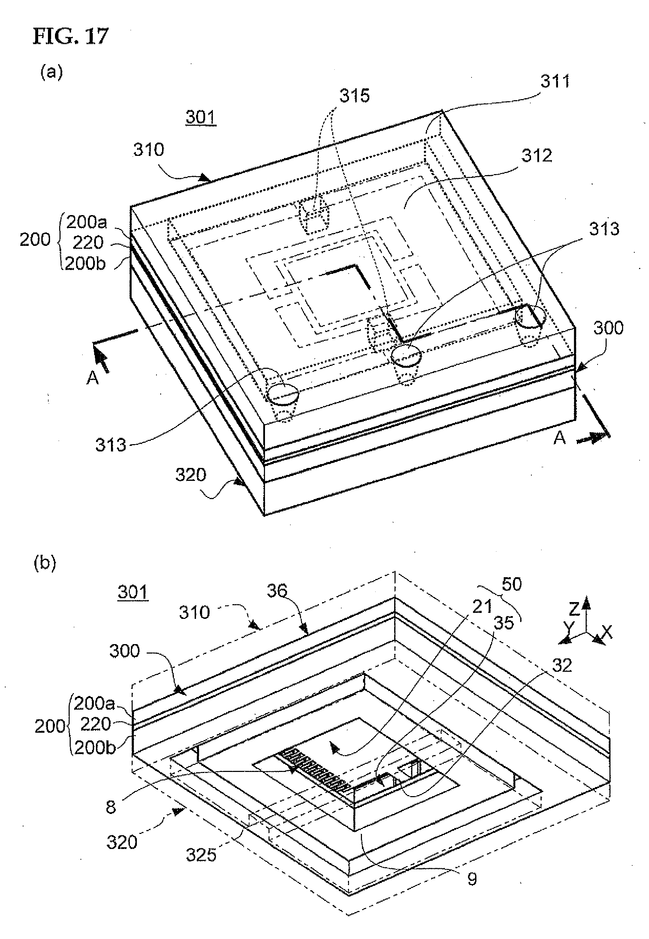

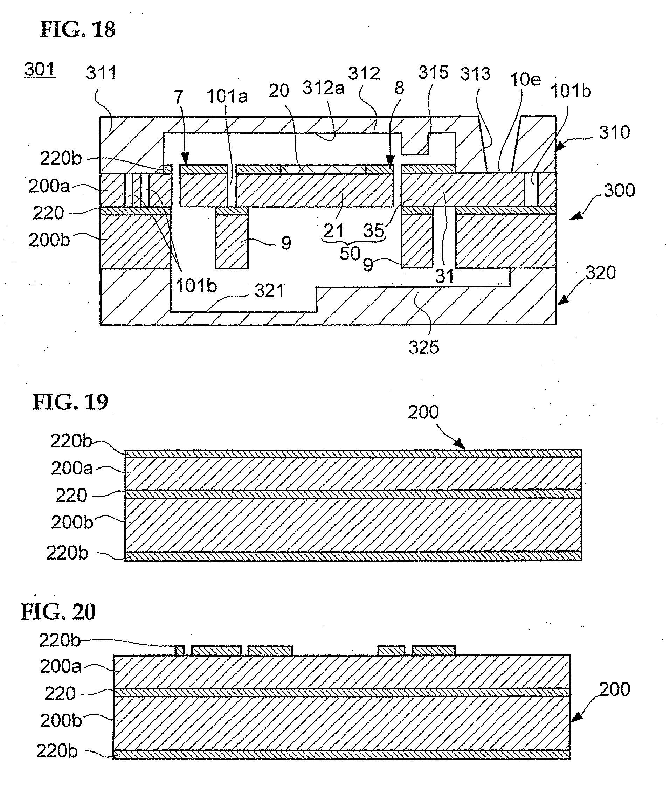

First, a configuration of the light scanning mirror 301 is described. As shown in FIG. 16, the light scanning mirror 301 has a semiconductor unit 300 which is configured of a triple-layered SOI (Silicon on Insulator) substrate (a semiconductor substrate) 200 consisting of a first silicon layer (activated layer) 200a and a second silicon layer (substrate layer) 200b having electric conductivity which are joined via a silicon oxidation film (BOX (Buried Oxide) layer) 220. Since the oxidation film 220 has electric insulation characteristic, the first silicon layer 200a and the second silicon layer 200b are electrically insulated each other. A thickness of the first silicon layer 200a is about 30µm, and a thickness of the second silicon layer 200b is about 400µm. In addition, an oxidation film 220b is formed on a part of a top face of the SOI substrate 200 (it is illustrated in FIG. 18). As shown in FIG. 17(a), the light scanning mirror 301 is a rectangular solid device that top face is substantially square or substantially rectangular of about several mm in planar view, and configured by the semiconductor unit 300, an upper protection substrate (protection substrate) 310 joined to a top face of the first silicon layer 200a, a lower protection substrate (protection substrate) 320 joined to a bottom face of the second silicon layer 200b, and so on.

As shown in FIG. 16, the semiconductor unit 300 comprises a moving plate 21 having substantially a rectangular shape in planar view and a mirror face 20 formed on a top face thereof, a moving frame 35 formed to be a substantially rectangular ring shape to surround peripheries of the moving plate 21, and a stationary frame 36 formed to surround peripheries of the moving frame 35 and to serve as side peripheries of the light scanning mirror 301. The moving frame 35 and the stationary frame 36 are coupled by bean shaped twin first hinges 31 which are formed from two side faces of the stationary frames 36 facing each other to cross at right angle to the faces to serve as an axis by arranged each other. On the other hand, the moving plate 21 and the moving frame 35 are coupled by beam shaped twin second hinges 32 which are formed to serve as an axis by arranged each other in a direction crossing a longitudinal direction of the first hinges 31 at right angle. The first hinges 31 and the second hinges 32 are formed so that the axes formed by them pass through a center of gravity of the moving plate 21 in planar view. Width dimensions of the first hinges 31 and the second hinges are respectively about 5µm and 30µm, for example. The moving plate 21 is supported by the moving frame 35 to be swingable with respect to the moving frame 35 around the second hinges 32 serving as an axis of the swing motion. On the other hand, the moving frame 35 is supported by the stationary frame 36 to be swingable with respect to the stationary frame 36 around the first hinges 31 serving as an axis of the swing motion. In other words, in this light scanning mirror 301, the moving plate 21 and the moving frame 35 constitute a moving plate 50 which is swingable with respect to the stationary frame 36 around the axis configured by the first hinges 31. The moving plate 21 is configured to be two-dimensionally swingable around two axes of the swing motions respectively configured by the first hinges 31 and the second hinges 32. As shown in FIG. 17(b), a supporting member 9, which is joined to the moving frame 35 so as to be swingable integrally with the moving frame 35, is provided on the bottom face of the moving frame 35. In addition, three through-hole connection areas 10d, 10e and 1 0f are formed on the stationary frame 36. Hereinafter, a longitudinal direction of the second hinges 32 is called X-direction, a longitudinal direction of the first hinges 31 is called Y-direction, and a direction perpendicular to the X-direction and the Y-direction is called Z-direction. In addition, the shapes of the moving plate 21, the mirror face 20 or the moving frame 35 is not limited to a rectangle, and, it may be a circle or an oval, for example.

The light scanning mirror 301 swings the moving plate 21 by electrostatic forces as driving forces, for example. In the semiconductor unit 300, first comb tooth electrodes 7 are formed at regions between the moving frame 35 and the stationary frame 36 where the first hinges 31 are not formed, and second comb tooth electrodes 8 are formed at regions between the moving plate 21 and the moving frame 35 where the second hinges 32 are not formed. The first comb tooth electrodes 7 are configured so that electrodes 3b respectively formed to be comb tooth shape on two side faces of the moving frame 35 substantially perpendicular to the X-direction are arranged to engage electrodes 4a respectively formed at positions on the stationary frame 36 facing the electrodes 3b. The second comb tooth electrodes 8 are configured so that electrodes 2a respectively formed to be comb tooth shape on two side faces of the moving plate 21 substantially perpendicular to the Y-direction are arranged to engage electrodes 3a respectively formed to be comb tooth shape at positions on the moving frame 35 facing the electrodes 2a. In the first comb tooth electrodes 7 and the second comb tooth electrodes 8, gaps between the electrodes 3b and 4a, and gaps between the electrodes 2a and 3a are configured to be from 2µm to 5µm, for example. The first comb tooth electrodes 7 and the second comb tooth electrodes 8 generate electrostatic forces acting in a direction of gravitation each other between the electrodes 3b and 4a or electrodes 2a and 3a when applying voltages between the electrodes 3b and 4a or electrodes 2a and 3a.

The moving plate 21, the moving frame 35, the stationary frame 36 and so on are formed by processing an SOI substrate 200 with micro machining technology, which will be mention later. Each portion of the semiconductor unit 300 including each layer of the SOI substrate 200 will be described below.

The moving plate 21 and the moving frame 35 are formed on a first silicon layer 200a.The mirror face 20 is a thin film of aluminum, for example, and formed on a top face of the moving plate 21 to reflect light beams incident from outside. The moving plate 21 is formed substantially symmetrical with respect to a perpendicular plane passing the second hinges 32 (a plane in parallel with z-x plane), and configured swingable around the second hinges 32, smoothly. As shown in FIG. 18, trenches 101a, which communicate from a top end to a bottom end of the first silicon layer 200a and constitute groove-shaped spaces reaching to an oxidation film 220, are formed on the first silicon layer 200a. By forming the trenches 101 a, the moving frame 35 is divided into five regions of a region which is connected to one of the first hinges 31 and integrated with the electrodes 3a and 3b, a region consisting of two pivoting portions 3c which support the second hinges 21 and a pivoting portion 3e which is connected to the pivoting portions 3c via a conductive portion 3d and pivoted by the other of the first hinges 31, and three balancing regions 3f formed to be point symmetrical to the conductive portion 3d with respect to a center of the moving plate 21. Since the trenches 101 a divide the first silicon layer 200a, these five regions are electrically insulated each other. In addition, the balancing regions 3f are not necessarily formed.

The supporting member 9 is configured of the oxidation film 220 and a second silicon layer 200b below the moving frame 35 (z-direction). The five regions of the moving frame 35 divided by the trenches 101a are joined with the supporting member 9. In other words, the supporting member 9 is formed below the regions of the moving frame 35 where the trenches 101a are formed while being joined with the first silicon layer 200a. In this way, the moving frame 35 and the supporting member 9 are configured to be swingable integrally around the first hinges 31 as the axis of the swing motion by joining the five regions on the supporting member 9. As shown in FIG. 17(b), the supporting member 9 is formed circularly to be substantially symmetrical with respect to the first hinges 31 in planar view to cover the regions of the bottom face of the moving frame 35 except the electrodes 3 a and 3b, in this embodiment. In addition, a thickness of the region of the supporting member 9 consisting of the second silicon layer 200b is formed to be substantially the same as a thickness of the region of the stationary frame 36 consisting of the second silicon layer 200b. In other words, the supporting member 9 is formed substantially symmetrical shape with respect to a perpendicular plane passing the first hinges 31 (a plane in parallel with a y-z plane). In addition, the trenches 101a of the moving frame 35 are provided at positions with shapes to be substantially symmetrical with respect to the perpendicular plane passing the first hinges 31 for forming the balancing regions 3f. Thereby, a center of gravity of the moving plate 50 including the supporting member 9 substantially coincides with the axis of the swing motion consisting of the first hinges 31 in planar view, so that the moving plate 50 including the supporting member 9 is configured to swing around the first hinges 31 smoothly and to perform scanning by the light scanning mirror 301 properly. In addition, the thickness of the portion of the supporting member 9 consisting of the second silicon layer 200b may be formed thinner or thicker than the thickness of the portion of the stationary frame 36 consisting of the second silicon layer 200b.

The stationary frame 36 is configured by the first silicon layer 200a, the oxidation film 220 and the second silicon layer 200b.
Three through-hole connection area 10d, 10e and 10f are formed and arranged on a top face of the stationary frame 36. Trenches 101b (grooves) are formed on the stationary frame 36 to divide the first silicon layer 200a into a plurality of regions, similar to the trenches 101a. Since the oxidation film 220 and the second silicon layer 200b are joined below the first silicon layer 200a and the trenches 101 b are formed on only the first silicon layer 200a, entire of the stationary frame 36 is formed integrally.

The trenches 101b divide the first silicon layer 200a of the stationary frame 36 into three regions which are electrically insulated each other and become substantially the same electric potentials as those of the through-hole connection areas 10d, 10e and 10f. Among these areas, an area to be the same electric potential as the through-hole connection area 10d has the pivoting portion 4d which supports one of the regions connected to the pivoting portions 3e of the moving frame 35 and distant farther from the through-hole connection area 10d. The through-hole connection area 10d and the pivoting portion 4d are connected by a conductive portion 4e which is formed narrower by forming the trenches 101b. In addition, the region which is to be substantially the same electric potential as that of the through-hole connection area 10e has the pivoting portion 4f which supports the other of the first hinges 31. The region which is to be substantially the same electric potential as that of the through-hole connection area 10f is the region of the stationary frame 36 except the above mentioned two regions to be the same electric potentials as those of the through-hole connection areas 10d and 10e, and the electrodes 4a are formed at this region.

In this way, three regions are provided on the first silicon layer 200a by forming the trenches 101a and 101b to include a region on which the through-hole connection area 10d is formed and which is to be substantially the same electric potential as that of the electrodes 2a, another region on which the through-hole connection area 10e is formed and which is to be substantially the same electric potential as that of the electrodes 3a and 3b of the moving frame 35, and still another region on which the through-hole connection area 10f is formed and which is to be substantially the same electric potential as that of the electrodes 4a of the stationary frame 36. Electric potentials of the through-hole connection areas 10d, 10e and 10f are variable from outside, which will be described later, and the first comb tooth electrodes 7 and the second comb tooth electrodes 8 are driven by varying the electric potentials of these through-hole connection areas 10d, 10e and 10f so that the light scanning mirror 301 can be driven. In other words, in this embodiment, the three regions of the first silicon layer 200a respectively including the through-hole connection areas 10d, 10c and 10f and electrically insulated each other constitute voltage application areas to apply voltages to the first comb tooth electrodes 7 and the second comb tooth electrodes 8. In addition, these three regions of the voltage application areas are electrically insulated by insulation areas including the trenches 101a and 101b, gaps between the moving plate 21 and the moving frame 35 and gaps between the moving frame 35 and the stationary frame 36 formed on the first silicon layer 200a.

The upper protection substrate 310 and the lower protection substrate 320 are respectively joined to the top face of the first silicon layer 200a and the bottom face of the second silicon layer 200b of the stationary frame 36. The upper protection substrate 310 has a joint portion 311 which is joined to the stationary frame 36, a light transmission portion 312 located above the moving plate 50, and three through-holes 313 respectively formed at positions corresponding to the through-hole connection areas 10d, 10e and 10f. As shown in FIG. 18, the light transmission portion 312 has a cavity structure, and a recess 312a which is graved from the bottom face side, that is, the semiconductor unit 300 side is formed so as not to block the swing motion of the moving plate 50. Two stoppers (upper stoppers) 315 are formed on the recess 312a. The through-holes 313 are formed so that the through-hole connection areas 10d, 10e and 10f are exposed on the top face in a state that the upper protection substrate 310 is joined to the semiconductor unit 300. In other words, the through-holes 313 serve as penetration electrodes to apply voltages to the through-hole connection areas 10d, 10e and 10f, so as to enable to apply voltages to the through-hole connection areas 10d, 10e and 10f while covering the top face of the semiconductor unit 300 by the upper protection substrate 310. The through-holes 313 are located substantially at centers of the through-hole connection areas 10d, 10e and 10f, and diameters of them are preferably smaller than dimensions of the through-hole connection areas 10d, 10e and 10f, and it should be about 0.5mm, for example.

In this embodiment, the stoppers 315 are provided to restrain the displacement of the moving plate 50 in the z-direction other than torsion direction. The stoppers 315 are provided to protrude toward the stationary frame 35 from portions of the recess 312a above the regions of the moving frame 35 where two of the first hinges 31 are respectively connected. In other words, the two stoppers 315 are respectively provided on the recess 312a to protrude toward the center axis of the swing motion of the moving plate 50. The stoppers 315 are formed so that the moving plate 50 does not approach to the first hinges 31 not to contact the first hinges 31 when it displaces. In other words, as shown in FIG. 18, the stoppers 315 are offset to the moving plate 50 (inwardly) from the first hinges 31 so as not to overlap the first hinges 31 in planar view. Thereby, the stoppers 315 never contact the first hinges 31. Therefore, it is possible to prevent the trouble of breakage of the first hinges 31 by contacting the stoppers 315 in the displacement of the moving plate 50. In addition, the stoppers 315 are arranged at outside of the moving plate 21 so as not to block the swing motion of the moving plate 21 (not to overlap the moving plate 21 in planar view). Bottom ends of the stoppers 315 serve as contacting portions which can contact the moving plate 50 when the moving plate 50 displaces in the z-direction. Since the moving plate 21 and the moving plate 50 are driven with swing angles about 10 degrees, for example, the stoppers 315 are formed as shapes in consideration with a scope where the moving plate 21 and the moving plate 50 displace in the swing motion. For example, it is formed that dimensions in the x-direction are to be 100µm to 400µm, and dimensions in the y-direction are to be 100µm to 300µm. Lower limits of these dimensions are set to enable to support the moving plate 50 by the stoppers 315 when the moving plate 50 contacts the stoppers 315. In addition, the stoppers 315 are formed to have gaps of about 10µm to 30µm in the z-direction between the top face of the moving plate 50 and it when the moving plate 50 is in a balanced position. In this way, by providing the stopper 315 on the upper protection substrate 310 proximate to the moving plate 50, the displacement of the moving plate 50 in the z-direction, that is, in the direction perpendicular to the semiconductor substrate is restrained. In addition, by forming the stoppers 315 in consideration with the scope of the displacement of the moving plate 21 and the moving plate 50 in the swing motion, the swing motions of the moving plate 21 and the moving plate 50 are never blocked in normal driving.

The lower protection substrate 320 has a cavity structure similar to the upper protection substrate 310, and a recess 321 which is graved at a portion corresponding to the moving plate 50 and the supporting member 9 from the top face, that is, the semiconductor unit 300 side so as not to block the swing motion of the moving plate 50.

In this embodiment, a stopper (lower stopper) 325 is provided on the lower protection substrate 320 similar to the upper protection substrate 310 to restrain the displacement of the moving plate 50 in the z-direction other than the torsion. The stopper 325 is provided at only one position to protrude as a rib shape along the axis of the swing motion of the first hinges 31 on the basis of the recess 321 forming a bottom of the lower protection substrate 320. In other words, the stopper 325 is provided to protrude as the rib shape toward the center axis of the swing motion of the moving plate 50. A top end of the stopper 325 serves as a contacting portion which can contact the supporting member 9 displacing integrally with the moving plate 50 in the displacement of the moving plate 50. As shown in FIG. 18, a distance between the first hinges 31 and the stopper 325 is maintained in a degree not to approach each other by the existence of the supporting member 9 provided on the bottom face of the moving frame 35, so that both parties never contact. A shape of the stopper 325 is set so as to support the moving plate 50 when the moving plate 50 contacts thereto in consideration with the scope of the displacement in the swing motion of the moving plate 50. For example, a dimension in the x-direction is set to be about 100 µm to 400µm. In addition, the stopper 325 is formed to have a gap about 10µm to 30µm in the z-direction between the moving plate 50 and it when the moving plate 50 is in the balanced state. Since the stopper 325 is provided near to the moving plate 50, the displacement of the moving plate 50 in the z-direction, that is, the direction perpendicular to the semiconductor substrate is restrained. In addition, since the stopper 325 is formed in consideration with the scope of the displacement in the swing motion of the moving plate 50, the swing motion of the moving plate 50 in the normal driving is never blocked. Besides, a dimension of protrusion of the stopper 325 may be modified preferably corresponding to existence or nonexistence of the supporting member 9 or the thickness of the supporting member 9 so as to restrain the quantity of the displacement of the moving plate 50 effectively. When the supporting member 9 is not provided or the thickness of the supporting member 9 is thin, it is preferable to form the stopper 325so as not to block the swing motions of the moving plate 21 and the moving plate 50 and not contact the first hinges 31 when the moving plate 50 displaces in the z-direction, similar to the stoppers 315.

In addition, since the upper protection substrate 310 and the lower protection substrate 320 protect internal semiconductor unit 300, it is sufficient to select the thickness about 0.5mm to 1.5mm, but it is preferable to be about 0.6mm, for example, in consideration with the size after the joining. In addition, it is preferable to select the depths of the recesses 312a and 321 to be about 0.3mm, for example, so as not to block the swing motion of the moving plate 50.

Furthermore, it is preferable that the upper protection substrate 310 should be a glass substrate because of the light transparency and the easiness to join it with the first silicon layer 200a. For example, when using a Pyrex (registered trademark) glass by Corning, it is superior in the transparency and it can be joined easily with the silicon by the anode joining because sodium is included in the glass. The upper protection substrate 310 may be formed integrally to include the recess 312a, the through-holes 313 and the stoppers 315 with using the glass substrate by molding method, bonding method, etching method or blast method. In addition, as for the lower protection substrate 320, a glass substrate can be used similar to the upper protection substrate 310. Besides, the materials of the upper protection substrate 310 and the lower protection substrate 320 are not limited to this. In addition, the stoppers 315 and the stopper 325 may be formed of a material different from that of the main bodies of the upper protection substrate 310 and the lower protection substrate 320 each, and they may be joined to the main bodies of the upper protection substrate 310 and the lower protection substrate 320. As for the upper protection substrate 310, it should be configured that at least the light transmission portion 312 is formed of a material which can transmit light beams to be scanned by the light scanning mirror 301. On the other hand, since the lower protection substrate 320 is not required the transparency other than the upper protection substrate 310, it can be configured of a material such as silicon which is easy to process.

Subsequently, the motion of the light scanning mirror 301 is described. The first comb tooth electrodes 7 and the second comb tooth electrodes 8 respectively serve as so-called perpendicular electrostatic combs, so that the moving plate 21 driven by generating driving forces at predetermined driving frequencies by the first comb tooth electrodes 7 and the second comb tooth electrodes 8. The first comb tooth electrodes 7 and the second comb tooth electrodes 8 are driven by varying the electric potentials of the electrodes 2a and the electrode 4a periodically in a state that the electrodes 3a and 3b are connected to the standard electric potential, for example, so that they generate electrostatic forces. In this light scanning mirror 301, the first comb tooth electrodes 7 and the second comb tooth electrodes 8 are respectively configured to generate the driving forces periodically by being applied voltages of rectangular waveforms, for example.

The moving plate 21 and the moving frame 35 formed as above do not take level postures and are inclined a little in a state of rest due to occurrence of internal stresses at the time of forming in many cases, generally. Therefore, when the first comb tooth electrodes 7 are driven from the state of rest, the driving forces act on the moving plate 21 in the direction substantially perpendicular to it, and thus, the moving plate 21 rotates around the second hinges 32 serving as the rotation axis, for example. Subsequently, when the posture of the moving plate 21 becomes in parallel with the moving frame 35, that is, in a state that the electrodes 2a and the electrodes 3a completely overlap in side view, the driving forces of the second comb tooth electrodes 8 are released, so that the moving plate 21 continues to rotate while twisting the second hinges 32 by inertia force thereof. When the inertia force of the moving plate 21 in a rotational direction becomes equal to the restitution forces of the second hinges 32, the rotation of the moving plate 21 in the direction stops. At this time, the second comb tooth electrodes 8 are driven again, and the moving plate 21 starts to rotate in the opposite direction by the restitution forces of the second hinges 32 and the driving forces of the second comb tooth electrodes 8. The moving plate 21 is swung by repeating such rotations due to the driving forces of the second comb tooth electrodes 8 and the restitution forces of the second hinges 32. The moving frame 31 repeats the rotation due to the driving forces of the first comb tooth electrodes 7 and the restitution forces of the first hinges 31, similar to the swing motion of the moving plate 21, and thus, it swings integrally with the supporting member 9. At this time, the moving plate 50 including the supporting member 9 swings entirely, and the posture of the moving plate 21 varies. Thereby, the moving plate 21 repeats two-dimensional swing motion.

The second comb tooth electrodes 8 are driven by applying the voltages having a frequency about two times as large as a resonance frequency of a vibration system configured of the moving plate 21 and the second hinges 32. In addition, the first comb tooth electrodes 7 are driven by being applied the voltages having a frequency about two times as large as a resonance frequency of a vibration system configured of the moving plate 21, the moving frame 35, the supporting member 9 and the first hinges 31. Thereby, the moving plate 21 is configured to be driven with resonance phenomenon so as to enlarge the swing angle thereof. In addition, since application manner and frequencies of the voltages of the first comb tooth electrodes 7 and the second comb tooth electrodes 8 are not limited to the above, it may be configured that the driving voltages are applied as sinusoidal wave forms, or it may be configured that the electric potentials of the electrodes 3a and 3b are varied with the electric potentials of the electrodes 2a and the electrodes 4a.

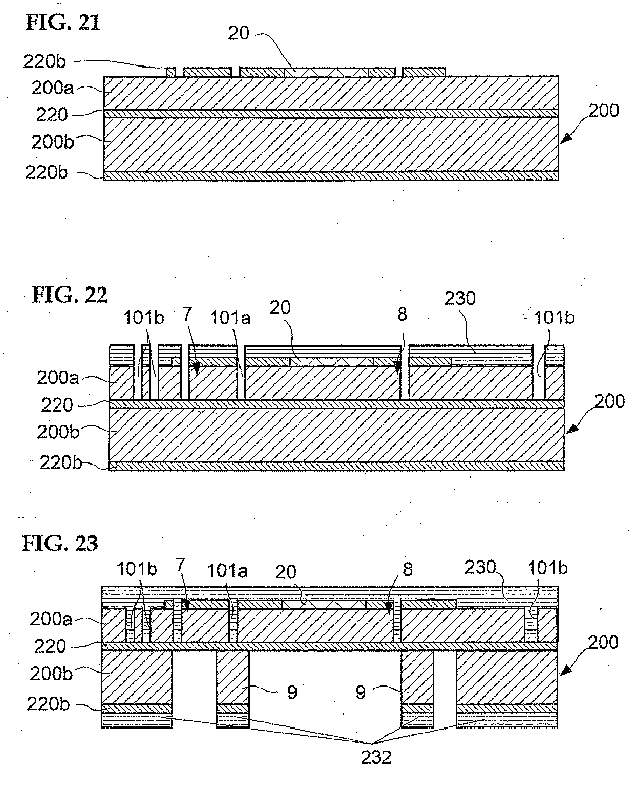

Manufacturing processes of the light scanning mirror 301 is described below with reference to FIG. 19 to FIG. 24. In addition, FIG. 19 to FIG. 24 are cross-sectional views of the region substantially the same region shown in FIG. 18. First, oxidation films are formed on both of top and bottom faces of an SOI substrate 200 in a diffusion furnace of oxygen and a steam atmosphere (FIG. 19). Subsequently, a resist (not illustrated) is patterned by photo lithography in the shapes of the moving plate 50, the first hinges 31 and the second hinges 32 on a surface of the oxidation film 220b formed on a top face of an activation layer, that is, a first silicon layer 200a. After that, regions of the oxidation film 220b which is not. masked by the resist is removed by RIE (Reactive Ion Etching) so as to expose the regions of the first silicon layer 200a in which the moving plate 50 and so on are not formed, and the resist is removed in oxygen plasma (FIG. 20). An aluminum film is formed on the top face of the first silicon layer 200a by sputtering aluminum, for example. The aluminum film is formed so that a thickness thereof becomes about 5,000 angstrom, for example. Then, after pattering a resist (not illustrated) by photo lithography, the RIE is performed to remove a portion of the aluminum film other than the mirror face 20, and the resist is removed (FIG. 21). Thereby, the mirror face 20 is formed.

After forming the mirror face 20, a resist 230 is patterned on the first silicon layer 200a, and etching an exposed portion of the top face of the first silicon layer 200a by performing D-RIE (Deep Reactive Ion Etching). Since an etching rate of the oxidation film 220 of the SOI substrate 200 is less than 1% of an etching rate of the first silicon layer 200a, the oxidation film 220b on the surface of the first silicon layer and the oxidation film 220 are rarely etched. Thereby, shapes to be the moving plate 50, the first hinges 31, the second hinges 32, the first comb tooth electrodes 7 and the second comb tooth electrodes 8 are formed on the first silicon layer 200a. Simultaneously, the trenches 101a are formed in a region to be the moving plate 50, and, the trenches 101b are formed in a region to be the stationary frame 36 (FIG. 22). The resist 230 is removed it in oxygen plasma.

Subsequently, a second silicon layer 200b (bottom face side) of the SOI substrate 200 serving as a supporting substrate is processed. The processing of the bottom face side is performed by covering the top face of the first silicon layer 200a which is the top face side by the resist 230 for protection, for example. First, a resist 232 is patterned on a surface of the oxidation film 220b formed on a surface of the second silicon layer 220b by photo lithography. The resist 232 is formed in shapes corresponding to the supporting member 9 and the stationary frame 36. Then, regions of the oxidation film 220b in which the resist 232 is not formed is etched by RIE and the exposed second silicon layer 200b is graved by D-RIE (FIG. 23). At this time, the second silicon layer 200b is graved to the oxidation film 220 due to the difference of the etching rates, similar to the above, and the oxidation film 220 is rarely etched. After that, the resist 232 is removed in oxygen plasma. In addition, it may be configured that the resist 232 is removed during etching of the second silicon layer 200b, and in that case, manufacturing processes can be simplified. Furthermore, it is possible to adjust a thickness of the resist 232 corresponding to the supporting member 9 so that the supporting member 9 is etched a little when the etching is completed, and thus, the thickness of the supporting member 9 is made smaller.

Subsequently, the oxidation film membrane 220 exposed below the semiconductor unit 300 is removed by RIE. Thereby, the moving plate 50 and the moving plate 21 become swinagble through the first hinges 31 and the second hinges 32 (see FIG. 16 or the like). In addition, thereby, the supporting member 9 consisting of the oxidation film 220 and the second silicon layer 200b is formed below the trenches 101 a in a state that a plurality of regions of the moving frame 35 insulated and divided by the trenches 101 are joined. In addition, the oxidation film 220b on the surface of the second silicon layer 200b is removed, simultaneously. After that, the semiconductor unit 300 is completed by removing the resists 230 and 232 above and below the semiconductor unit 300.

After completion of the semiconductor unit 300, the upper protection substrate 310 and the lower protection substrate 320 are joined to the semiconductor unit 300. In this embodiment, it is described the case of using the glass substrates as the upper protection substrate 310 and the lower protection substrate 320. The glass substrates and the SOI substrate 200 can be joined easily and surely by the anode joining, for example.

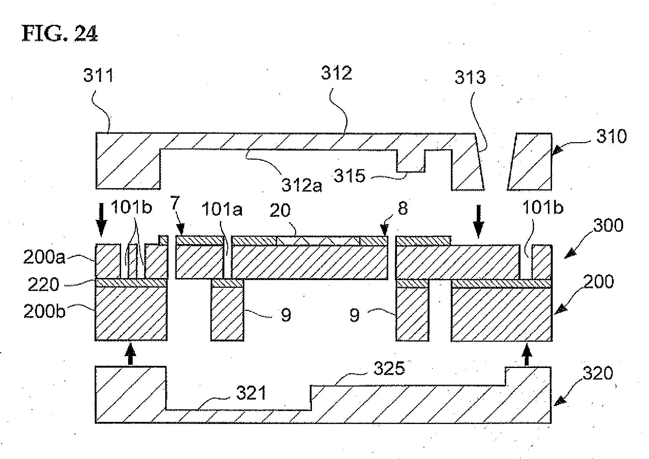

The joining processes of the upper protection substrate 310 and the lower protection substrate 320 are performed so that the upper protection substrate 310 is joined to top side of the semiconductor unit 300 first in consideration with protection of the mirror face 20 and the lower protection substrate 320 is joined to the bottom side of the semiconductor unit 300 afterword. In the joining process of the upper protection substrate 310, the glass substrate to which the recess 312a and the through-holes 313 are formed is superposed on the SOI substrate 200 of the semiconductor unit 300 first and heated to about several hundred degrees Celsius under vacuum environment of lower than 10 Pa. At this time, degree of vacuum after joining can be enhanced much higher by making the environment less than 1 Pa, preferably. In addition, it is preferable to keep the temperature about 300 degrees Celsius to 400 degrees Celsius. After that, when the glass substrate and the SOI substrate 200 became desired temperature, a voltage of about 400V to 800V with respect to the silicon layer, that is, the first silicon layer 200a of the SOI substrate 200 to be joined is applied to the glass substrate. By keeping the state of applying the voltage in about 20 minutes to 60 minutes, the upper protection substrate 310 properly joined to the semiconductor unit 300. After joining the upper protection substrate 310, the lower protection substrate 320 is joined to the second silicon layer 200b of the semiconductor unit 300 by the anode joining similar to the above (FIG. 24), so that the light scanning mirror 301 shown in FIG. 18 is completed. In addition, the joining method is not limited to the anode joining, and it is possible to join by using various kinds of methods.

As mentioned above, since the displacement of the moving plate 50 in the z-direction is restrained by the stoppers 315 and 325 in this embodiment, it is possible to prevent the breakage of the first hinges 31 and to enhance the crashworthy of the light scanning mirror 301 even when a mechanical shock is applied to the light scanning mirror 301 from outside. Since the stoppers 315 and 325 are formed to protrude toward the axis of the swing motion at which displacement of the moving plate 50 is small in the displacement of the moving plate 50, it is possible to configure the stoppers proximate to the moving plate 50, and to restrain the displacement of the moving plate 50 in the z-direction effectively. Since the stoppers 315 and 325 are disposed above and below the moving plate 50 in this embodiment, effect to enhance the crashworthy can be obtained effectively.

In addition, the present invention is not limited to the configuration of the above mentioned embodiment, and it is possible to modify in various manners in a scope not to change the purpose of the invention, in the seventh embodiment. For example, structures, positions and number of the stopper 315 and the stopper 325 are not limited to those in the embodiment, and they can select optimum ones in consideration with the swing motion of the light scanning mirror. More specifically, the stopper 315 and the stopper 325 can disposed to restrain the displacement of the moving plate 21 in thickness direction which is arranged inside the moving frame 35. In other words, the stoppers 315 may be protruded toward the center axis of the swing motion of the second hinges 32 to overlap the moving plate 21 in planar vies, and the stopper 325 may be protruded along the center axis of the swing motion of the second hinges 32. In addition, the light scanning mirror is not limited to biaxial gimbals type in the above mentioned embodiment, and, it may be one which can swing around a single axis having a structure that a moving plate to which a mirror face is formed is supported by twin hinges on a stationary frame, for example. In this case, by forming stoppers on a protection substrate to protrude an axis of swing motion of the moving plate, the crashworthy of the light scanning mirror can be enhanced, similarly. Still furthermore, the protection substrate may be joined to at least a part of the semiconductor unit 300, and the stoppers may be disposed at least a side of the semiconductor unit 300 to restrain the displacement of the moving plate. When the stoppers are provided on only a side, the displacement of the moving plate in the z-direction can be restrained by the stoppers, and thus, it is possible to prevent the breakage of the hinges and to enhance the crashworthy. Still furthermore, the semiconductor unit 300 may be a single silicon substrate or a metal plate other than the SOI substrate, the driving forces to swing the moving plate 21 and the moving plate 50 may be electrostatic forces acting between flat electrodes, electromagnetic forces, electrostriction forces or heatstriction forces instead of the electrostatic forces acting between comb tooth electrodes. In any case, by forming the stoppers on the protection substrate to protrude toward the axis of the swing motion of the moving plate, it is possible to restrain the displacement of the moving plate in the z-direction, and thus, it is possible to prevent the breakage of the hinges and to enhance the crashworthy of the semiconductor unit.

Still furthermore, the present invention is not limited to a light scanning mirror having a mirror face to scan light beams, and it is widely applicable to a semiconductor moving structure that a moving plate which is configured swingable with respect to a stationary frame by twin hinges is formed on a semiconductor substrate. In other words, it is possible to enhance crashworthy of the semiconductor moving structure by providing stoppers on a protection substrate provided on at least one face of the semiconductor substrate to restrain a displacement of the moving plate in a direction perpendicular to the semiconductor substrate.

### List of Marks

1: light scanning mirror (moving structure)
2: moving plate
2e: recess
3: hinges
4: stationary frame (frame)
5: comb tooth electrodes
6: stoppers
6a: chamfers
9: supporting member
10: mirror face
315: upper stoppers
325: lower stopper

## Claims

1. A moving structure comprising: a moving plate; twin hinges constituting an axis of swing motion of the moving plate wherein an end of each hinge is connected to the moving plate; and a frame to which another end of each of the twin hinges is connected and which supports the hinges, and wherein
the moving plate is configured swingable with respect to the frame while twisting the twin hinges, **characterized in that**
stoppers, which restrain a displacement of the moving plate by contacting a part of the moving structure when the moving plate displaces, are further comprised.

2. The moving structure in accordance with claim 1, **characterized in that**
the stoppers are provided to restrain the displacement of the moving plate in in-plane direction,.

3. The moving structure in accordance with claim 1 or claim 2, **characterized in that**
the stoppers are formed along the hinges in sides of the hinges.

4. The moving structure in accordance with claim 1 or claim 2, **characterized in that**
comb tooth electrodes, which are formed on a part of the moving plate and a part of the frame to face each other, and swing the moving plate with respect to the frame, are further comprised; and
the stoppers are disposed to contact another portion of the moving structure except the comb tooth electrodes, when the moving plate displaces in the in-plane direction.

5. The moving structure in accordance with one of claim 1 to claim 4, **characterized in that** the stoppers are integrally formed with the moving plate or the frame.

6. The moving structure in accordance with claim 3, **characterized in that**
recesses are provided on the moving plate so that they are formed to be concaved in a longitudinal direction of the hinges in the vicinities of portions pivoted by the hinges; and
the stoppers are integrally formed with the frame and formed to be located between the hinges and side end portions of the moving plate to which the recesses are formed.

7. The moving structure in accordance with one of claim 1 to claim 6, **characterized in that**
a chamfer of a round shape is formed at each corner of the stoppers.

8. The moving structure in accordance with one of claim 1 to claim 7, **characterized in that**
the stoppers are configured to be the same electric potential as that of another portion of the moving structure which contacts the stopper when the moving plate displaces in a lateral direction.

9. The moving structure in accordance with one of claim 1 to claim 8, **characterized in that**
a sticking prevention film or a protrusion is formed on at least a part of each of the stopper so as not to occur sticking between the stopper and one which contacts the stopper.

10. The moving structure in accordance with claim 1, **characterized in that**
the stoppers are provided to restrain the displacement of the moving plate in thickness direction.

11. The moving structure in accordance with claim 10, **characterized in that**
the moving plate, the hinges and the frame are provided on a semiconductor substrate;
a protection substrate for protecting the moving plate is joined to at least one face of the semiconductor substrate; and
the stoppers are protruded toward a center axis of swing motion of the moving plate from the protection substrate.

12. The moving structure in accordance with claim 11, **characterized in that**
the stoppers are formed at positions distant from the hinges so as not to contact the hinges when the moving plate displaces.

13. The moving structure in accordance with claim 12, **characterized in that**
each of the stoppers include an upper stopper disposed in a top face side of the moving plate; and
the upper stopper is formed to protrude toward a center axis of swing motion of the hinges so as to restrain the displacement of the moving plate by contacting the moving plate in displacement of the moving plate.

14. The moving structure in accordance with claim 12, **characterized in that**
a supporting member is integrally formed with the moving plate below a bottom face of the moving plate;
the stoppers include a lower stopper disposed in a bottom face side of the moving plate; and
the lower stopper is formed to protrude toward a center axis and along the center axis of swing motion of the hinges so as to restrain the displacement of the moving plate by contacting the supporting member which displaces integrally with the moving plate in displacement of the moving plate.

15. A light scanning mirror having the moving structure in accordance with one of claim 1 to claim 14; and
a mirror face for reflecting incident light is provided on a top face of the moving plate.
